# EUROPEAN PATENT APPLICATION

(11) **EP 4 848 977 A1**
(43) Date of publication of application: **02.12.2026**
(21) Application number: 25224263.1
(22) Date of filing: 17.12.2025
(51) Int. Cl.: H10W 80/00, H10W 72/90, H10W 90/20

(54) **3D HETEROGENEOUS INTEGRATION OF SRAM CHIPLETS**

(30) Priority: 26.05.2025 US 202519218432
(71) Applicant: Intel Corporation, Santa Clara, CA 95054 (US)
(72) Inventor: ELSHERBINI, Adel, Chandler, 85248 (US); BHARGAVA, Mudit, Austin, 78746 (US); SALAHUDDIN, Shairfe, Portland, 97229 (US); LIFF, Shawna Marie, Scottsdale, 85255 (US); KIM, Gwang-Soo, Portland, 97229 (US); KRISHNATREYA, Bhaskar Jyoti, Beaverton, 97007 (US); SWAN, Johanna, Scottsdale, 85255 (US); SINGH, Gurpreet, Beaverton, 97006 (US); OSBORN, Tyler, Sherwood, 97140 (US); GATIMU, Alvin Joel, Hillsboro, 97124 (US); SHI, Yi, Chandler, 85248 (US); EID, Feras, Chandler, 85226 (US); MACKIEWICZ, Ryan, Beaverton, 97006 (US); GSTREIN, Florian, Portland, 97212 (US); PHILLIPS, Mark, Hillsboro, 97124 (US); WALLACE, Charles Henry, Portland, 97212 (US); NASKAR, Sudipto, Portland, 97229 (US)
(74) Representative: 2SPL Patentanwälte PartG mbB

(57) **Abstract**

Three-dimensional (3D) heterogeneous integrated circuit components comprise one or more chiplets stacked on a base die. The chiplets are heterogeneous to the base die in the functionality they implement, the manufacturing process used to fabricate the dies (allowing for chiplet and base die manufacturing processes to be independently optimized or tailored), or in any other manner. For example, the integrated circuit component can be a system-on-a-chip with the chiplets implementing SRAM or DRAM functionality. In some embodiments, the chiplets can comprise just the SRAM or DRAM bitcell arrays with the SRAM or DRAM peripheral circuitry (e.g., word line drivers) being located on the base die. In another example, different logic standard cell types (e.g., high-performance, high-density, low leakage) can be split across chiplets and a base die, again allowing for the manufacturing processes used to fabricate the chiplets and base die to be optimized or tailored independently.

## Description

### BACKGROUND

3D heterogeneous integration is a semiconductor packaging technique that stacks and interconnects multiple integrated circuit dies to enhance performance, functionality, and density. This approach allows designers to overcome the limitations of traditional 2D scaling by vertically integrating diverse integrated circuit components into a single package.

### BRIEF DESCRIPTION OF THE DRAWINGS

FIG. 1 is a cross-section of a first example 3D heterogeneous integrated circuit structure comprising chiplets attached to a backside metallization stack of a base die.
FIG. 2 is a cross-section of a second example 3D heterogeneous integrated circuit structure comprising a chiplet embedded in a frontside metallization stack of a base die.
FIG. 3 is a cross-section of a third example 3D heterogeneous integrated circuit structure comprising a chiplet attached to a top of a frontside metallization stack of a base die.
FIG. 4 is a cross-section of a fourth example 3D heterogeneous integrated circuit structure comprising a chiplet embedded in a frontside metallization stack of a base die.
FIG. 5 is a cross-section of a fifth example 3D heterogeneous integrated circuit structure illustrating various chiplet connectivity approaches.
FIG. 6 comprises an example six-transistor SRAM bitcell (6T SRAM) circuit that can be implemented as part of an SRAM bitcell array on a chiplet.
FIG. 7 illustrates example physical design outlines of several types of standard cells.
FIG. 8 illustrates example physical designs of an inverter standard cell implemented using different transistor types.
FIGS. 9A-9B illustrates an example division of logic standard cells among a bonded die and a base die in a 3D heterogeneous integrated circuit component.
FIG. 10 is a cross-section of a sixth example 3D heterogeneous integrated circuit structure utilizing a hybrid of logic standard cells.
FIG. 11 is a cross-section of an example high-performance inverter standard cell.
FIGS. 12A-12D illustrate cross-sections of example GAAFET high-performance inverter standard cells.
FIGS. 13A-13D illustrate an example sequence of processing steps to fabricate a 3D heterogenous integrated circuit structure with a chiplet embedded in a frontside metallization stack of a base die.
FIG. 14 illustrates an example sequence of processing steps to fabricate a 3D heterogenous integrated circuit structure with hybrid logic dies.
FIG. 15 is a first example method of forming a 3D heterogeneous integrated circuit structure.
FIG. 16 is a top view of a wafer and dies that may be included in a microelectronic assembly or integrated circuit structure, in accordance with any of the embodiments disclosed herein.
FIG. 17 is a cross-sectional view of an integrated circuit structure that may be included in any of the chiplets or base dies described herein.
FIGS. 18A-18D are perspective views of example planar, FinFET, gate-all-around, and stacked gate-all-around transistors.
FIG. 19 is a cross-sectional view of an integrated circuit device assembly that may include any of the microelectronic assemblies or integrated circuit structures disclosed herein.
FIG. 20 is a block diagram of an example electrical device that may include a microelectronic assembly or integrated circuit structure, in accordance with any of the embodiments disclosed herein.

### DETAILED DESCRIPTION

3D heterogeneous integration allows diverse integrated circuit dies to be stacked vertically in a single packaged integrated circuit component. The shorter interconnections between dies can reduce signal latency and power consumption compared to traditional 2D packaging. The integrated circuit dies assembled into a 3D heterogeneous integrated circuit component can be heterogeneous in terms of functionality, performance characteristics, density, or other vectors. For example, the manufacturing process used to fabricate transistors for a high-performance central processing unit (CPU) can be optimized or tailored independently from the manufacturing process used to fabricate low-leakage transistors for DRAM integrated circuit dies to be attached to the CPU.

Disclosed herein are 3D heterogeneous integrated circuit components comprising a base die and one or more smaller integrated circuit dies stacked on top of the base die. The chiplets are heterogeneous with respect to the base die in one or more aspects. The integrated circuit dies attached to the base die may be referred to herein as "chiplets". "Chiplets" are typically referred to as such due to their smaller size (relative to the base die) and their dedicated functionality, but as used herein, the term "chiplet" is not to be construed as imposing any limitation on the size or functionality of integrated circuit dies stacked on top of a base die.

The chiplets disclosed herein have a metallization stack that is built up to a middle-level metal layer (e.g., metal 3 (M3), metal 4 (M4), metal 5 (M5), metal 6 (M6), metal 7 (M7), or metal 8 (M8) layer). The top-most layer of the chiplet metallization stack is attached to a middle metal layer of the base die metallization stack via hybrid bonding, with the bond pads (pads) having a pitch of 500 nanometers or less. The bonding of a chiplet middle metal layer to a base die middle metal layer is enabled by this fine hybrid bonding pitch and allows for dense signal routing between the chiplets and base die. Chiplets can be bonded to a frontside metallization stack or a backside metallization stack of a base die. The chiplets can further be embedded within or attached to the top of a base die metallization stack. In the latter case, the top-most layer of a chiplet metallization stack can connect to a middle metal layer of a base die metallization stack by high-aspect ratio vias. Further, individual chiplets or a stack of chiplets can be bonded to a base die. Moreover, multiple individual chiplets and/or chiplet stacks can be stacked on a base die. Multiple chiplets attached to a base die can vary in size and/or functionality from each other.

In a first set of embodiments, chiplets implementing SRAM functionality are attached to a base die. The SRAM circuitry can be split between the base die and one or more chiplets, with the individual chiplets comprising an array (or bank) of SRAM bitcells and the base die comprising SRAM peripheral circuitry (e.g., word line drivers, write drivers, sense amps). Fine pitch hybrid bonding allows for word line (WL) and bitline (BL) signals to be transferred between the chiplets and the base die in an area-efficient manner. In some SRAM chiplet embodiments, a portion of the SRAM peripheral circuitry can be incorporated into the SRAM chiplets.

In a second set of embodiments, chiplets implementing DRAM functionality are attached to a base die. The DRAM circuitry can be split between the base die and one or more chiplets, with the individual chiplets comprising an array of DRAM bitcells and the base die comprising DRAM peripheral circuitry (e.g., word line drivers, refresh circuitry, sense amps). In some DRAM chiplet embodiments, a portion of the DRAM peripheral circuitry can be incorporated into the DRAM chiplets.

In a third set of embodiments, different types of logic standard cells (e.g., high-performance, high-density, low-power) are distributed across a base die and one or more chiplets, with the base die and individual chiplets each being dedicated to one logic standard cell type. This allows for the processes used to manufacture the chiplets and base dies to be optimized or tailored independently.

The 3D heterogeneous integration technologies and integrated circuit components fabricated by such technologies have at least the following advantages. First, chiplets can be fabricated using a different manufacturing process than the one used to fabricate the base die, allowing for the different processes to be optimized or tailored independently to achieve desired base die and chiplet performance characteristics. This can result in an improvement in overall integrated circuit component performance. The number of manufacturing processes that can be optimized or tailored for a 3D heterogeneous integrated circuit component can be more than two, given that multiple chiplets can be attached to a base die and that different chiplets can be manufactured by different processes.

Second, by bonding individual chiplets (or chiplet stacks) to a base die, which is a chip-to-wafer (C2W) attachment approach, there is more freedom to separate SRAM and DRAM bitcell arrays from SRAM and DRAM peripheral circuitry, which can result in a more efficient use of integrated circuit die area. In 3D heterogeneous integrations employing a wafer-to-wafer (W2W) bonding approach (where the dies being bonded are substantially the same lateral size) to an integrated circuit die containing only SRAM bitcells to a base die, large amounts of the attached integrated circuit die may be left unused, leading to inefficient area utilization. Thus, attaching chiplets to a base die via a C2W approach instead of a W2W approach can result in a more efficient use of integrated circuit area, resulting in cost savings.

Third, the use of fine pitch hybrid bonding to attach chiplets to a base die allows for the efficient routing of high-density signals (e.g., word lines, bitlines) between the chiplets and the base die, resulting in higher integrated circuit component performance.

Fifth, by separating the processing of chiplets implementing DRAM functionality from the processing of the CMOS logic located on the base die, the CMOS logic implemented in the base die can be spared from high-temperature DRAM processing. This can be advantageous as CMOS logic can be more sensitive to high-temperature processing than DRAM circuitry. The stacking of chiplets via hybrid bonding to form a chiplet stack prior to the attachment of a chiplet stack to a base die may also address the thermal challenges of building chiplet stacks monolithically on a base die.

Sixth, splitting logic standard cells by type across the base die and one or more chiplets can improve performance and yield. The yield of integrated circuit components comprising multiple logic standard cell types (e.g., high-performance, high-density) can be limited by the yield of the lowest-yielding standard cell type (typically the high-density standard cells), and performance can be improved by the vertical routing between standard cells on the chiplet and base die being shorter than the lateral routing between standard cells of different types on a base die implementing hybrid logic standard cells.

In the following description, specific details are set forth, but embodiments of the technologies described herein may be practiced without these specific details. Well-known circuits, structures, and techniques have not been shown in detail to avoid obscuring an understanding of this description. Phrases such as "an embodiment," "various embodiments," "some embodiments," and the like may include features, structures, or characteristics, but not every embodiment necessarily includes the particular features, structures, or characteristics.

Some embodiments may have some, all, or none of the features described for other embodiments. "First," "second," "third," and the like describe a common object and indicate different instances of like objects being referred to. Such adjectives do not imply that objects so described must be in a given sequence, either temporally or spatially, in ranking, or any other manner.

Reference is now made to the drawings, which are not necessarily drawn to scale, wherein similar or same numbers may be used to designate same or similar parts in different figures. The use of similar or same numbers in different figures does not mean all figures including similar or same numbers constitute a single or same embodiment. Like numerals having different letter suffixes may represent different instances of similar components. The drawings illustrate generally, by way of example, but not by way of limitation, various embodiments discussed in the present document.

In the following description, for purposes of explanation, numerous specific details are set forth in order to provide a thorough understanding thereof. It may be evident, however, that the novel embodiments can be practiced without these specific details. In other instances, well-known structures and devices are shown in block diagram form in order to facilitate a description thereof. The intention is to cover all modifications, equivalents, and alternatives within the scope of the claims.

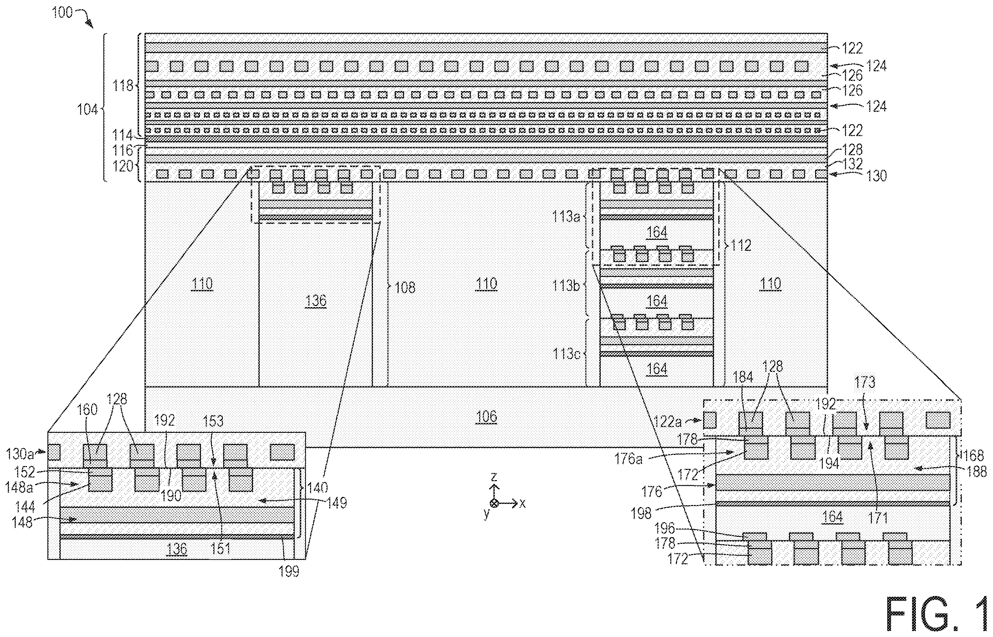

FIG. 1 is a cross-section of a first example 3D heterogeneous integrated circuit structure comprising chiplets attached to a backside metallization stack of a base die. The integrated circuit structure (structure 100) comprises a base integrated circuit die (base die 104) with a chiplet 108 and a chiplet stack 112 attached to the base die 104. The chiplet stack 112 comprises chiplets 113a, 113b, and 113c. The chiplet 108 and the chiplets 113a-113c are heterogeneous from the base die 104. Chiplets 108 and 113a-113c, as well as any other chiplet attached to a base die described herein, can be heterogeneous from the base die in that they are fabricated using a different manufacturing process than the manufacturing process used to fabricate the metal die, implement a functionality not implemented in the base die, or in any other fashion. For example, as will be discussed in greater detail below, the chiplets 108 and 113a-113c can comprise SRAM bitcells with the base die 104 implementing corresponding SRAM peripheral circuitry. In some embodiments, the structure 100, as well as any other integrated circuit structure described herein, can be a system-on-a-chip (SoC).

The structure 100 comprises a device layer 114 comprising transistors. The device layer 114 is on a substrate 116. Any transistor described or referenced herein (e.g., planar field-effect transistors (FETs), FinFETs, gate-all-around FETs (GAAFETs)) that is part of a device layer can be considered to be located on a substrate that the device layer is located on. The structure 100 further comprises a first plurality of interconnect layers that form a frontside metallization stack 118 and a second plurality of interconnect layers that form a backside metallization stack 120. The frontside metallization stack 118 comprises metal traces 122 belonging to metal layers 124 that are separated by dielectric layers 126 (an interconnect layer of a metallization stack comprises a metal layer and a dielectric layer) and the backside metallization stack 120 comprises several metal traces 128 belonging to metal layers 130 that are separated by dielectric layers 132. Through-silicon vias (TSVs, not shown) provide electrically conductive paths between the backside metallization stack 120 and the frontside metallization stack 118. As used herein, the term "frontside" in reference to an integrated circuit structure feature, such as a metallization stack, refers to a feature that is located on the same side of a substrate as a device layer. Frontside metallization stacks can also be referred to as back-end-of-line (BEOL) metallization stacks. As used herein, the term "backside " refers to a feature, such as a metallization stack or bonding pad, that is located on the opposite side of a substrate from a device layer.

The chiplet 108 and the chiplet stack 112 are within a layer 110 and between a layer 106 and the base die 104. The layer 106 can provide structural integrity to the structure 100. The layers 106 and 110 can comprise silicon (e.g., bulk silicon), a material comprising silicon and nitrogen (e.g., silicon nitride, SiₓN_{y}), a material comprising silicon and oxygen (e.g., silicon dioxide, SiO₂), or any other suitable material. In any of the embodiments herein, a chiplet can have a supporting substrate added to it to improve the mechanical resilience of the chiplet during assembly of the chiplet to the base die. A supporting substrate can comprise silicon, a dielectric material (e.g., SiO₂, SiₓN_{y}), or other suitable material. The supporting substrate can be removed after chiplet attachment to a base die by mechanical grinding, chemical mechanical polishing (CMP), dry etch, or any other suitable means. In some embodiments, an additional layer of dielectric material may be added between a supporting substrate and a chiplet substrate for use as an etch stop during the supporting substrate removal step. This additional layer may be observable in a final integrated circuit structure or integrated circuit component.

In some embodiments, the chiplet 108 and the chiplet stack 112 are attached to the base die 104 via hybrid bonding of the chiplet 108 and the chiplet stack 112 to the backside metallization stack 120 of the base die 104. The chiplet 108 comprises a substrate 136, a metallization stack 140, and a device layer 199 positioned between the substrate 136 and the metallization stack 140. Metal traces 144 of a top-most layer 148a of the metallization stack 140 are electrically conductively coupled to pads 152 (bonding pads), and several metal traces 128 of a top-most layer 130a of the backside metallization stack 120 are electrically conductively coupled to pads 160. As used herein, the term "top-most layer" as it refers to an interconnect layer in a metallization stack refers to the interconnect layer of a metallization stack that is furthest away from a device layer or substrate. The hybrid bonding of the chiplet 108 to the base die 104 comprises bonding the pads 152 of the chiplet 108 to the pads 160 of the base die 104 and bonding dielectric material 151 located between the pads 152 to dielectric material 153 located between the pads 160. Any of the pads described or referenced herein in hybrid bonding can be round, square, rectangular, cross-shaped, or any other suitable shape.

The chiplet stack 112 comprises chiplets 113a-113c in a stacked arrangement. Each of the chiplets 113a-113c has a similar structure to the chiplet 108, comprising a substrate 164, a metallization stack 168, and a device layer 198 positioned between the substrate 164 and the metallization stack 168. The substrate 164 can be thinned (as shown in FIG. 1) relative to the substrate 136 of chiplet 108. The chiplet stack 112, as well as any other chiplet stack described or referenced herein, can be formed before the chiplet stack 112 is bonded to the base die 104 or formed monolithically with the base die during base die fabrication. In the latter scenario, a chiplet 113a is first bonded to the base die 104, with the chiplet 113a then thinned and further processed to form through-silicon vias (TSVs, not shown) and bonding pads (e.g., pads 196) in the substrate 164 to allow for a second chiplet (chiplet 113b) to be bonded to the first chiplet (chiplet 113a). This process can be repeated until the chiplet stack 112 is formed. Although three chiplets are shown in the chiplet stack 112, any of the chiplet stacks described or referenced herein can have any number of chiplets.

Metal traces 172 of a top-most metal layer 176a of the metallization stack 168 are electrically conductively coupled to pads 178, and several metal traces 128 of the top-most layer 122a of the backside metallization stack 120 are electrically conductively coupled to pads 184. The hybrid bonding of the chiplet stack 112 to the base die 104 comprises bonding the pads 178 to the pads 184 and bonding the dielectric material 171 located between the pads 178 to the dielectric material 173 located between the pads 184. The metal layers 148 in the metallization stack 140 are separated by dielectric layers 149, and the metal layers 176 in the metallization stack 168 are separated by dielectric layers 188.

At a high level, the process of hybrid bonding involves bonding the metal and dielectric regions of two surfaces that are in contact with each other. For example, the hybrid bonding of chiplet 108 and chiplet stack 112 to the base die 104 involves first bringing a surface 190 of the chiplet 108 into contact with a surface 192 of the base die and a surface 194 of the chiplet stack 112 into contact with the surface 192 of the base die, and then performing an annealing step while these surfaces are in contact. Annealing promotes strong bonding between the dielectric materials and allows the bonding pads to expand and fuse to create a strong electrical connection. In some of the hybrid bonds illustrated herein, the pads that are part of the bond are shown as being misaligned by a small amount. This illustrates that some misalignment between components being hybrid bonded can occur and that a certain level of alignment is tolerable.

In order to enable a high-density of connections between base dies and chiplets, any of the pads that are used to attach a chiplet to a base die have a pitch of less than about 500 nanometers. In some embodiments, the chiplet bond pads can have a pitch that substantially matches (i.e., is within +/- 10% of) the metal pitch of a middle layer of a frontside or backside metallization stack of the base die. For example, chiplet pads can have a pitch in the range of about 20 nm to about 150 nm to match the metal pitch in middle interconnect layers in advanced semiconductor manufacturing technology nodes.

Any of the chiplets described or referenced herein can have a "shortened" frontside metallization stack. That is, the number of interconnect layers in the frontside metallization stack of the chiplet is less than the number of interconnect layers that the manufacturing process used to fabricate the chiplet is capable of producing. For example, in some embodiments, a chiplet fabricated using a manufacturing process that is capable of producing nine or more interconnect layers may have at least four but no more than eight interconnect layers in a frontside metallization stack. As used herein, reference to a "middle layer" of a metallization stack can refer to any interconnect layer other than the bottom-most interconnect layer in the metallization stack (the interconnect layer closest to the device layer) or the top-most layer that the manufacturing process is capable of producing. For example, in a manufacturing process capable of producing 10 interconnect layers (M1 through M10), a middle layer can refer to any of the metal 2 (M2) through metal 9 (M9) interconnect layers.

Any chiplets in any of the chiplet stacks described or referenced herein can comprise pads on the backside of the chiplet to allow for vertically adjacent chiplets to be bonded. For example, the top two chiplets (chiplets 113a, 113b) in the chiplet stack 112 comprise backside pads (pads 196) to allow for hybrid bonding between vertically adjacent chiplets. For example, the pads 196 of chiplet 113a are bonded to the pads 178 of the middle chiplet (chiplet 113b) in the chiplet stack 112.

In some embodiments, bonding pads that are part of a hybrid bond are electrically conductively coupled to a metal trace either by being directly attached to the metal trace, such as pads 152 being directly attached to metal traces 144, or attached to a metal trace by an intervening via. Bonding pads that are directly attached to a metal trace can be formed by a damascene process, and bonding pads that are attached to a metal trace by an intervening via can be formed by a dual damascene process. Although the chiplet-to-base die bonds illustrated in FIG. 1 are shown as comprising dielectric-to-dielectric bonds, in some embodiments, the metal layer in a metallization stack closest to a bonding interface (in the chiplet and/or base die metallization stack) may be an air gap interconnect layer to reduce parasitic capacitance. In such interconnect layers, the regions between the metal traces are occupied by air instead of a dielectric material. The regions between bonding pads can be occupied by air instead of a dielectric material as well. Air gap interconnects may also be used in the chiplet and/or base die metallization stack and can be used at any bonding interface described herein (e.g., base die-to-chiplet, chiplet-to-chiplet).

In any of the integrated circuit structures or components disclosed herein formed via 3D heterogeneous integration, a chiplet can have a lateral area that is less than the lateral area of the base die. In some embodiments, a chiplet can have a lateral area that is more than 75%, 50%, 30%, 10%, or any other percentage of the lateral area of the base die. With reference to FIG. 1, the lateral areas of the chiplet 108 and the base die 104 are the areas they occupy in the x- and y-dimensions.

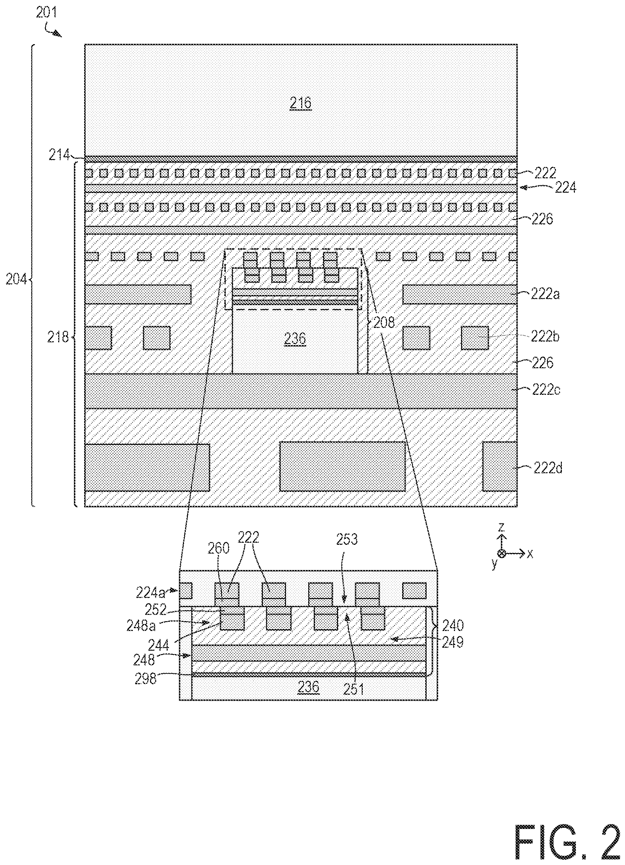

FIG. 2 is a cross-section of a second example 3D heterogeneous integrated circuit structure comprising a chiplet embedded in a frontside metallization stack of a base die. The structure 201 comprises a base integrated circuit die (base die 204) and a chiplet 208 embedded in a frontside metallization stack 218 of the base die 204. The structure 201 comprises a device layer 214 comprising transistors. The device layer 214 is on a substrate 216. The frontside metallization stack 218 comprises a plurality of interconnect layers, individual of the interconnect layers comprising a dielectric layer 226 and metal traces 222 belonging to a metal layer 224.

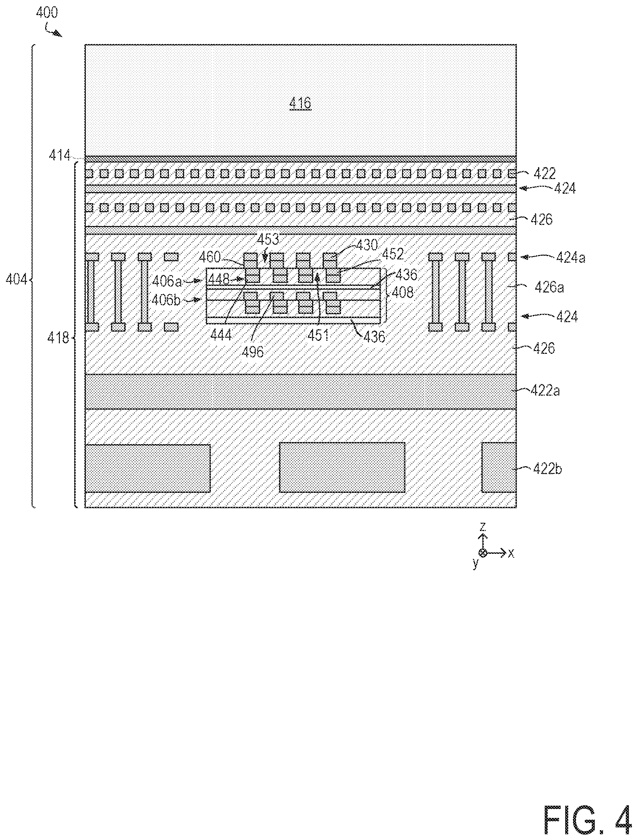

The chiplet 208 is embedded in the frontside metallization stack 218, extending through the interconnect layers of the frontside metallization stack 218 that include metal traces 222a and 222b, and covered by the interconnect layers that include metal traces 222c and 222d. In some embodiments, a chiplet embedded within a metallization stack of a base die is not covered by an interconnect layer of a base die metallization stack. In some embodiments, a chiplet stack can be embedded within a base die metallization stack (see FIG. 4). The chiplet 208 comprises a substrate 236, a metallization stack 240, and a device layer 298 positioned between the substrate 236 and the metallization stack 240. Metal traces 244 of a top-most interconnect layer 248a of the metallization stack 240 are electrically conductively coupled to pads 252, and metal traces 222 of a middle interconnect layer 224a of the frontside metallization stack 218 are electrically conductively coupled to pads 260. The metal layers 248 in the metallization stack 240 are separated by dielectric layers 249.

The chiplet 208 is attached to the frontside metallization stack 218 via hybrid bonding. The hybrid bond of the chiplet 208 to the base die 204 is formed by bonding pads 252 of the chiplet 208 to pads 260 of the base die 204 and bonding dielectric material 251 located between the pads 252 to dielectric material 253 located between the pads 260. Although FIG. 2 illustrates a chiplet embedded within a frontside metallization stack, in other embodiments, a chiplet (or chiplet stack) can be similarly embedded within a backside metallization stack.

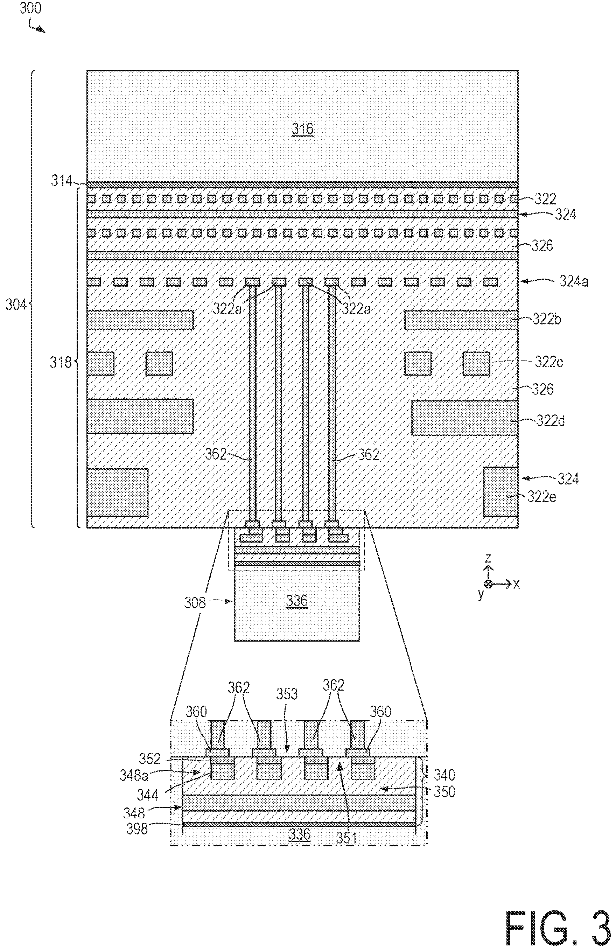

FIG. 3 is a cross-section of a third example 3D heterogeneous integrated circuit structure comprising a chiplet attached to a top of a frontside metallization stack of a base die. The structure 300 comprises a base integrated circuit die (base die 304) and a chiplet 308 attached to the base die 304. The chiplet 308 is attached to the "top" of the frontside metallization stack 318 in that all interconnect layers of the frontside metallization stack 318 are positioned between the chiplet 308 and the base die 304. The structure 300 comprises a device layer 314 comprising transistors. The device layer 314 is on substrate 316 and is positioned between the substrate 316 and a plurality of interconnect layers that form the frontside metallization stack 318. The frontside metallization stack 318 comprises metal traces 322 belonging to metal layers 324 that are separated by dielectric layers 326.

The chiplet 308 comprises a substrate 336, a metallization stack 340, and a device layer 398 positioned between the substrate 336 and the metallization stack 340. Traces 344 of a top-most layer 348a of the metallization stack 340 are electrically conductively coupled to pads 352. The metal layers 348 in the metallization stack 340 are separated by dielectric layers 350.

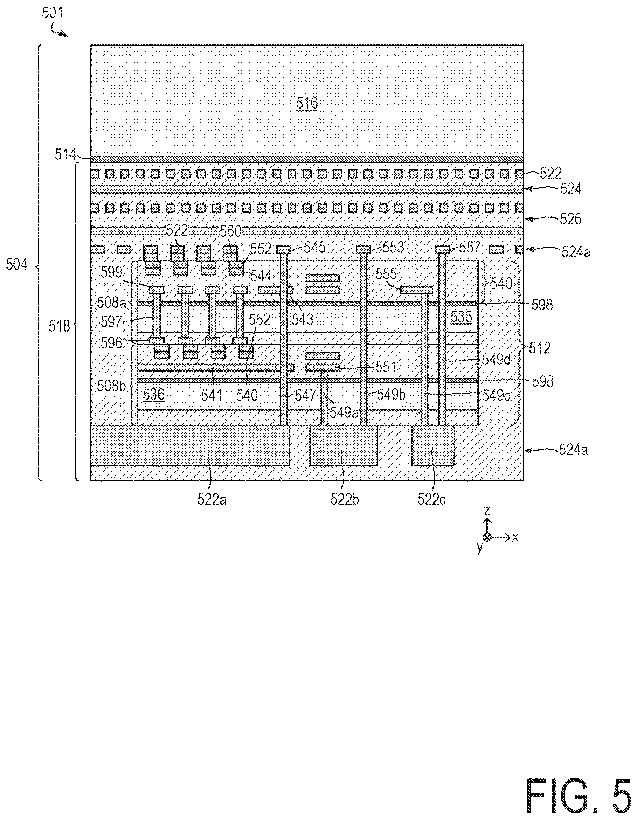

The chiplet 308 can be attached to the base die 304 via hybrid bonding. The hybrid bond of the chiplet 308 to the base die 304 can be made by bonding pads 352 of the chiplet 308 to pads 360 of the frontside metallization stack 318 of the base die and bonding dielectric material 351 located between the pads 352 to dielectric material 353 located between the vias 362. The pads 360 are attached to vias 362. Each via 362 is attached at a first end to a pad 360 and at a second end to a trace 322a of a metal layer 324a of the frontside metallization stack 318. The vias 362 are high-aspect ratios that extend through interconnect layers comprising metal traces 322b, 322c, 322d, and 322e of the frontside metallization stack 318. High-aspect ratio vias connecting chiplet pads to base die pads can extend through more or fewer interconnect layers (or no interconnect layers (see FIG. 5)) than shown in FIG. 3. In some embodiments, high-aspect ratios are connected directly to traces in a chiplet or base die metallization stack. For example, with reference to FIG. 3, in some embodiments, the vias 362 can connect directly to traces 344 (pads 352 are absent).

Although a single chiplet is shown as being embedded in a front metallization stack, in other embodiments, a chiplet stack can be embedded with a frontside metallization stack and attached to the base die via hybrid bonding. Further, although FIG. 3 illustrates a chiplet attached to the top of a base die frontside metallization stack and connecting to a middle layer of the frontside metallization using via high-aspect ratio vias, in other embodiments, a chiplet (or chiplet stack) can be similarly attached and connected to a base die backside metallization stack.

FIG. 4 is a cross-section of a fourth example 3D heterogeneous integrated circuit structure comprising a chiplet stack embedded in a frontside metallization stack of a base die. The structure 400 comprises a base integrated circuit die (base die 404) and a device layer 414 comprising transistors. The device layer 414 is on a substrate 416. The structure 400 further comprises a plurality of interconnect layers that form a frontside metallization stack 418. The frontside metallization stack 418 comprises metal traces 422 belonging to metal layers 424 that are separated by dielectric layers 426.

The structure 400 further comprises a chiplet stack 408 comprising a pair of chiplets (chiplets 406a and 406b) in a stacked configuration. Chiplet stack 408 is embedded in the frontside metallization stack 418, extends through a dielectric layer 426a of one of the interconnect layers of the frontside metallization stack 418, and is covered by interconnect layers of the frontside metallization stack 418 that include metal traces 422a and 422b. Chiplets 406a and 406b each comprise a substrate 436, a frontside metallization stack, and a device layer (not shown) positioned between the substrate 436 and the metallization stack. Metal traces 444 of a top-most layer 448 of the metallization stack are electrically conductively coupled to pads 452, and metal traces 430 of a middle layer 424a of the frontside metallization stack 418 are electrically conductively coupled to pads 460 of chiplet 406a.

In some embodiments, the chiplet stack 408 is attached to the frontside metallization stack 418 via hybrid bonding. The hybrid bond of the chiplet stack 408 to the base die 404 is formed by bonding pads 452 of the chiplet stack 408 to the pads 460 of the base die 404 and by bonding dielectric material 451 located between the pads 452 to dielectric material 453 located between the pads 460. Chiplet 406a further comprises pads 496 located on a back surface of chiplet 406a to allow for hybrid bonding between chiplets 406a and 406b, which comprises bonding the pads 496 of chiplet 406a to pads 452 of chiplet 406b.

FIG. 5 is a cross-section of a fifth example 3D heterogeneous integrated circuit structure illustrating various chiplet connectivity approaches. The integrated circuit structure (structure 501) comprises a base integrated circuit die (base die 504) and a chiplet stack 512 that comprises chiplets 508a and 508b attached to the base die 504. The structure 501 comprises a device layer 514 comprising transistors. The device layer 514 is on a substrate 516. The structure 501 further comprises a plurality of interconnect layers that form a frontside metallization stack 518. The frontside metallization stack 518 comprises metal traces 522 belonging to metal layers 524 that are separated by dielectric layers 526.

The chiplet stack 512 is embedded in the frontside metallization stack 518, and is covered by an interconnect layer of the frontside metallization stack 518 that includes metal traces 522a, 522b, and 522c. Chiplets 508a and 508b each comprise a substrate 536, a metallization stack 540, and a device layer 598 positioned between the substrate 536 and the metallization stack 540. Metal traces 544 of a top-most layer of the metallization stack 540 of chiplet 508a are electrically conductively coupled to pads 552 and metal traces 522 of a top-most layer 524a of the frontside metallization stack 518 are electrically conductively coupled to pads 560. Chiplet stack 512 is hybrid bonded to the base die 504, which comprises pads 552 being bonded to pads 560.

In a first chiplet connectivity approach illustrated in FIG. 5, through-silicon via (TSVs) allow for communication between stacked chiplets. For example, pads 596 of chiplet 508a located on a back side of the chiplet 508a that are attached to pads 552 of chiplet 508b and TSVs 597 allow chiplets 508a and 508b to communicate by providing an electrically conductive path between traces 599 of the metallization stack 540 and pads 596 of chiplet 508a.

In a second chiplet connectivity approach, a trace of a base die interconnect layer located on a chiplet stack (or individual chiplet) can connect to a trace of a chiplet interconnect layer by a via. For example, metal trace 522a of the frontside metallization stack 518 connects to a trace 541 of chiplet 508b, a trace 543 of chiplet 508a, and a trace 545 of the frontside metallization stack 518 of the base die by a via 547. The via 547 can be formed by a via processing method that etches through chiplet substrates, chiplet metal traces, and chiplet metallization stack dielectric regions, but stops on metal traces of the base die metallization stack. Such via processing methods can comprise covering metal traces of the base die metallization stack with a via etch stop layer.

In a third chiplet connectivity approach, illustrated by vias 549a, 549b, 549c, and 549d, base die interconnect layer traces covering a chiplet can connect to chiplet interconnect layer traces by vias that are formed using a via processing method that comprises an etch that etches through chiplet substrates and chiplet metallization stack dielectric regions, but that does not etch through chiplet metallization stack traces. Metal trace 522b of the frontside metallization stack 518 of the base die 504 is connected to trace 551 of the metallization stack 540 of chiplet 508b by via 549a, metal trace 522b is connected to trace 553 of the metallization stack of the base die 504 by via 549b, metal trace 522c of the base die is connected to trace 555 of the metallization stack 540 of chiplet 508a by via 549c, and metal trace 522c of the base die 504 is connected to trace 557 of the frontside metallization stack 518 of the base die 504 by a via 549d. A manufacturing process can include any one of or any combination of the chiplet connectivity approaches illustrated in FIG. 5.

As discussed previously, the heterogeneity between a base die and an attached chiplet can be manifested in a difference in functionality, manufacturing process differences, or in other ways. In some embodiments, the heterogeneity between a base die and an attached chiplet can be that the chiplet comprises SRAM or DRAM functionality.

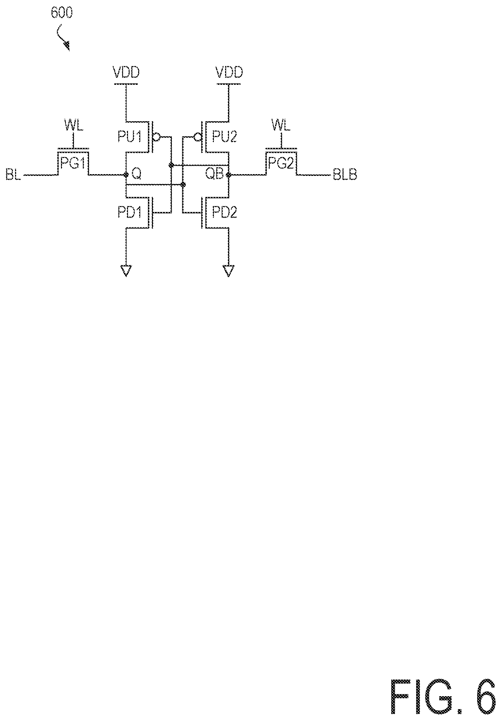

FIG. 6 comprises an example six-transistor SRAM bitcell (6T SRAM) circuit that can be implemented as part of an SRAM bitcell array on a chiplet. Any of the chiplets described herein comprising SRAM bitcells can comprise the bitcell 600. The bitcell 600 comprises a pair of pull-up transistors (PU1, PU2) and a pair of pull-down transistors (PD1, PD2) in a cross-coupled inverter configuration, and a pair of pass gates (PG1, PG2) that control access to the bitcell storage nodes (Q, QB). A word line signal (WL) controls the pass gate transistors, allowing the bitlines (BL, BLB) to be selectively connected to the storage nodes. The bitcell 600 can be referred to as a single-port bitcell or a one-read one-write (1R1W) SRAM bitcell. In some embodiments, any of the chiplets comprising SRAM bitcells can comprise multiport SRAM bitcells, such as two-read two-write (2R2W) or three-read three-write (3R3W) bitcells. Multiport SRAM bitcells differ from single-port bitcells in that they have additional pairs of pass gates in parallel with pass gates PG1, PG2. Each additional pair of pass gates is controlled by a wordline that is separate from that illustrated in FIG. 6, and each additional pair of pass gates connects the storage nodes of the bitcell 600 to a pair of bitlines that are separate from the bitlines illustrated in FIG. 6. In still other embodiments, chiplets can comprise other types of static random-access memories, such as a content-addressable memory (CAM).

The splitting of an SRAM bitcell array and SRAM peripheral circuitry between chiplets and a base die takes advantage of the fine pitch of the bonding pads used to attach the chiplets to a base die. The traces carrying wordline (WL), bitline (BL), power, and ground signals to an SRAM (or DRAM) bitcell array are densely packed as they are being delivered to transistors that are also densely packed. As such, these signals are typically routed in a middle layer of a metallization stack that has a metal pitch tight enough to allow these signals to be delivered to the densely packed SRAM bitcells. In some embodiments, this middle layer metal pitch can be in the range of about 20 nm to about 200 nm. By being able to attach a chiplet to a base die at a bond pad pitch that substantially matches (i.e., within +/- 5%) the metal pitch of a middle layer of a base die metallization stack, SRAM bitcell array signals (WL, BL, power, ground) can be efficiently routed between chiplets implementing SRAM bitcells and a base die implementing SRAM peripheral circuitry.

In some embodiments, a chiplet implementing SRAM functionality can comprise the SRAM bitcell arrays (or banks) and SRAM peripheral circuitry, such as word line drivers, bitline precharge circuitry, address decode logic, sense amps, write drivers, input/output (I/O) circuitry, and control logic. In other embodiments, a chiplet may comprise only SRAM bitcell arrays, and the SRAM periphery circuitry can be implemented on the base die. This can allow for the manufacturing processes used to fabricate the chiplet and the base die to be optimized or tailored independently. For example, the base die manufacturing process may be tailored for high-performance transistors (i.e., transistors that have a high drive current) and the chiplet process may be tailored for high-density layouts (i.e., integrated circuit die circuitry that is capable of being more densely packed). In other embodiments, chiplets and base dies can be manufactured using different technology nodes (e.g., 90 nm, 45 nm, 14 nm, 10 nm, 7 nm). The use of a technology node that is not a leading-edge technology to manufacture either the chiplet or the base die can result in cost savings. Different manufacturing processes being used to fabricate chiplets and base dies can manifest themselves in a difference in, for example, transistor gate pitch, metal 1 (M1) pitch, M1 thickness, transistor type (e.g., planar, FinFET, GAAFET), substrate (e.g., bulk CMOS, silicon-on-insulator (SOI), III-IV substrates), etc. In some embodiments, an SRAM bitcell array for a single SRAM may be distributed across multiple chiplets. Further, in some embodiments, multiple SRAMs (each of which can be implemented in one or more chiplets) can be attached to a single base die.

In addition to SRAM functionality being split between chiplets and a base die along bitcell and peripheral circuit lines, in some embodiments, the periphery circuitry can be split between chiplets and a base die. For example, a first word line driver stage could be implemented in a base die and a second word line driver stage could be implemented in one or more chiplets. Similarly, a first bitline encoding stage could be implemented in one or more chiplets and a second bitline encoding stage could be implemented in a base die.

DRAM functionality can be similarly split between chiplets and a base die. In some embodiments, a DRAM bitcell array can be implemented in one or more chiplets and DRAM peripheral circuitry (e.g., refresh circuitry, word line drivers, write drivers, sense amps, address decoders, control logic, I/O drivers) can be implemented in a base die. The access gates in DRAM bitcells implemented in the chiplets can be any type of metal oxide field-effect transistors (MOSFETs), such as MOSFETs fabricated on a crystalline substrate comprising silicon or thin-film transistors (e.g., transistors with indium gallium zinc oxide (IGZO), amorphous silicon, polycrystalline silicon, or 2D materials (e.g., MoS₂, WS₂) as the channel material). In some embodiments, DRAM peripheral circuitry can be split between chiplets and a base die, similar to as discussed above for how SRAM peripheral circuitry can be divided by chiplets and a base die. In other embodiments, DRAM bitcells are split between the base die and a chiplet, with bitcell access gates located in the base die and bitcell capacitors located in the chiplet. In such embodiments, the DRAM chiplets may not comprise any transistors. In some embodiments, the DRAM bitcell capacitors are substantially vertically oriented in the chiplet. That is, the capacitors extend primarily along a direction that is +/- 5 degrees of orthogonal to the substrate of the base die to minimize the lateral area occupied by the capacitors.

In embodiments where chiplets implement SRAM or DRAM bitcell arrays, the chiplets can comprise redundancy row and/or column redundancy to improve yield. These redundant rows and columns can be hanging rows and columns that are connected to word line and bitline signals by fusing after determining that a failing bitcell array die can be repaired by enabling row or column redundancy.

In some embodiments, multiple chiplets implementing one or more functionalities can be attached to a single base die. For example, in some embodiments, multiple chiplets implementing SRAM functionality can be attached to a single base die. The individual chiplets can include the same or a different number of bitcells (SRAM chiplets implementing different bitcell counts can thus occupy different lateral areas) and different SRAM chiplets can comprise different SRAM bitcell types (e.g., 1R1W, 2R2W). Similarly, in other embodiments, multiple chiplets implementing DRAM functionality can be attached to a single die. The chiplets can have the same or a different number of bitcells (DRAM chiplets implementing various bitcell counts can thus occupy different lateral areas). Further, one or more chiplets implementing SRAM functionality and one or more chiplets implementing DRAM functionality can be attached to a single base die. In embodiments where multiple individual chiplets are attached to a single base die, any number of chiplets (e.g., more than 5, 10, 20, 50) can be attached to a base die and the multiple chiplets can be located on the base die in any arrangement or configuration.

Moreover, in some embodiments, where a base die comprises both frontside and backside metallization stacks, one or more chiplets can be attached to the frontside metallization stack (frontside chiplets) and one or more chiplets can be attached to the backside metallization stack (backside chiplets) in any manner described herein, such as embedded within a metallization stack or located on top of a metallization stack. The frontside and backside chiplets can be heterogeneous from each other (and from the base die) in any manner described herein, such as in the manufacturing process used to fabricate the chiplet or the functionality realized in the chiplet. For example, one or more frontside chiplets can implement SRAM functionality and one or more backside chiplets can implement DRAM functionality.

In some embodiments, a 3D heterogeneous integrated circuit component can comprise an SoC base die that has a high memory requirement, and the cumulative lateral areas of one or more chiplets implementing SRAM or DRAM functionality stacked on the SoC can be 20-80% of the lateral area of the base die. In some embodiments, an integrated circuit component comprising heterogeneous chiplets attached to a base die can implement an in-memory compute structure, where a majority of the lateral area of the base die is covered by chiplets implementing SRAM and DRAM bitcell arrays and a minority of the lateral area of base die is capable of performing computations or other operations on data read from or to be written to the bitcell arrays.

In some embodiments, a chiplet stack can comprise multiple chiplets implementing SRAM functionality or multiple chiplets implementing DRAM functionality. Such stacks can be formed prior to attachment of the chiplet stack to a base die or formed monolithically as part of base die fabrication.

As mentioned previously, in addition to chiplet and base die heterogeneity comprising a difference in functionalities, chiplet and base die heterogeneity can be due to a chiplet and a base die each comprising circuitry comprising logic standard cells of a specific type. Logic standard cell libraries are an important part of designing an integrated circuit. The physical design of an integrated circuit, which is used to generate the photomasks that are used during manufacturing to print the features on a wafer needed to implement an integrated circuit design, comprises a set of polygons drawn at various layers, such as a gate layer, contact, and metal 1 (M1) layer. Electronic design automation (EDA) tools allow processor architects and circuit designers to design circuits at levels of abstraction above the physical design level. Architects typically define their designs using a hardware design language (HDL), such as VHDL or Verilog. Once they have verified that their designs perform as desired, a physical design can be automatically generated using libraries of standard cells, with the individual standard cells in a particular library implementing a particular function. For example, standard cells in a logic standard cell library can implement functions such as inverters, basic logic gates (e.g., AND, OR, NAND, NOR, and-or-inverter (AOI) gates), multiplexers, flops, and adders.

As used herein, the term "standard cell" can refer to any electronic representation or physical manifestation of a standard cell, such as the layout of a standard cell in an EDA tool or an integrated circuit structure that realizes a standard cell design. The term "logic standard cell" refers to any standard cell that is part of a standard cell library that implements a variety of functions (e.g., AND, NOR, NAND gates, flops). Although standard cells implementing memory bitcells (such as SRAM or DRAM bitcells) can be implemented in standard cell libraries for a manufacturing process, logic standard cells differ from memory bitcell standard cells in the variety of functionalities they can implement.

This variety in logic standard cell functionality can result in a block of logic circuitry appearing differently from a memory array when viewed in a plan view. A block of logic circuitry can comprise multiple rows of logic standard cells, and these rows of logic standard cells appear different from rows of memory bitcell standard cells. The arrangement of gate and lower-level metal (e.g., one or more of the M1 through M4 layers) trace features in a row of memory cells is periodic as a row of memory bitcell standard cells comprises the same memory bitcell, whereas in a row of logic standard cells adjacent logic standard cells can implement different functions and the arrangement of gate and lower-level metal trace features across such rows of logic standard cells are aperiodic. Further, the arrangement of gate features and lower-level metal trace features in adjacent rows of memory standard cells is periodic in the column direction as well as adjacent rows in a memory array comprise the same memory bitcell. In contrast, adjacent rows of logic standard cells can have different combinations of logic standard cells and can thus have different arrangements of gate and lower-level metal trace features.

For a given manufacturing process, it is common for several types of standard cell libraries to be available for designers to utilize, such as high-performance, high-density, ultra-high-density, and low-power, with each standard cell library handling the integrated circuit power-area-speed tradeoff differently. Integrated circuit designs often comprise a mix of standard cells taken from various libraries, with the standard cells selected for use in a particular circuit typically being driven by power-area-speed tradeoff considerations. High-performance standard cells are tailored for speed and typically have transistors with wider widths to enable high transistor drive currents. High-density standard cells are optimized to have a size smaller than high-performance standard cells and typically have lower-performance transistors with narrower widths. Thus, high-performance standard cells are typically used in critical paths and high-density cells can be used in non-critical paths.

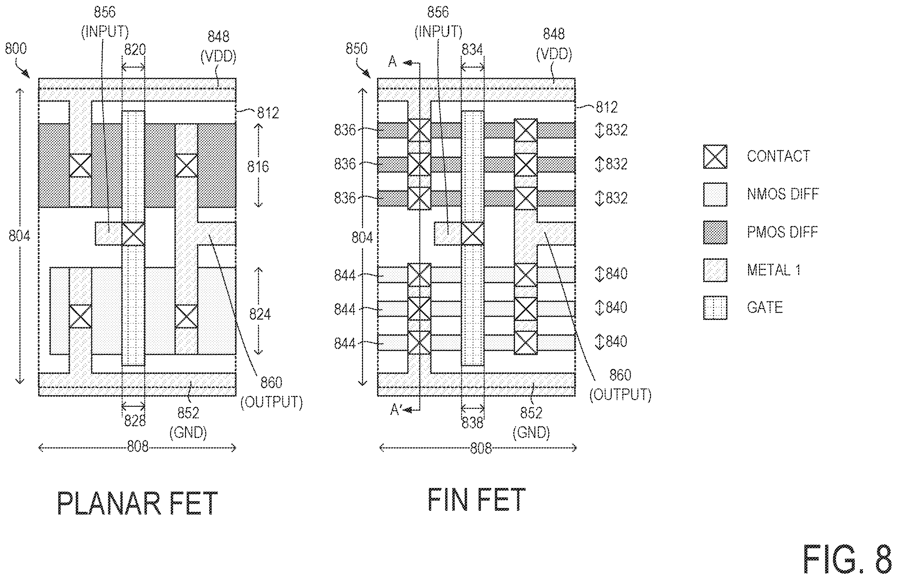

With their wider transistors, high-performance standard cells are typically larger than their high-density counterparts (see FIG. 8). The transistors in different standard cell libraries (high performance transistors) can further vary in channel length. For example, transistors in high performance standard cells can have a channel length that is the minimum transistor channel length for a manufacturing process and transistors in low-power and high density standard cell libs (low-power transistors, high density transistors) can have a channel length that is greater than the minimum channel length for a manufacturing process to enable low-leakage transistors. High-performance and high-density or low power transistors can further have different threshold voltages (VTs), with high-performance transistors having a lower VT than high-density or low power transistors. In some manufacturing processes, high density or low power transistors can have a gate oxide that is thicker than the gate oxide used in high-performance transistors to enable transistors with lower gate leakage. Ultra-high-density standard cells can be even smaller than high-density standard cells, with further area reduction realized with tightly packed layouts and transistors smaller than those used in high-density cells.

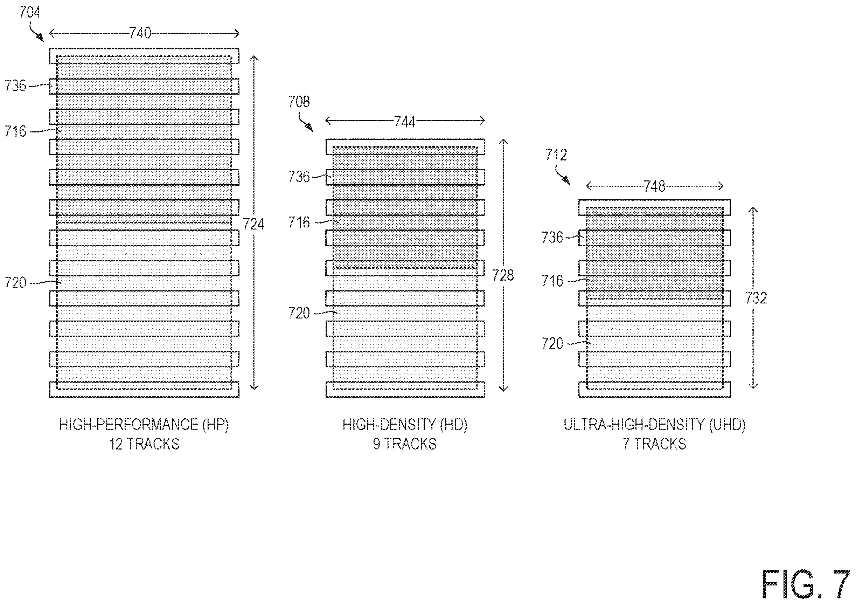

FIG. 7 illustrates example physical design outlines of several types of standard cells. FIG.7 illustrates outlines of the physical design (or "layouts") of a high-performance standard cell (layout 704), a high-density standard cell (layout 708), and an ultra-high-density standard cell (layout 712). The layouts 704, 708, and 712 each comprise a p-type diffusion region 716 and an n-type diffusion region 720 in which p-type metal-oxide-silicon field-effect transistors (PMOS) and n-type metal-oxide-silicon field-silicon (NMOS) transistors are located (transistors not shown in FIG. 7), respectively. The layouts 704, 708, and 712 have heights 724, 728, and 732, respectively, and widths 740, 744, and 748, respectively. The height 724 of the high-performance standard cell is greater than the height 728 of the high-density standard cell, which in turn is greater than the height 732 of the ultra-high-density standard cell.

The layouts 704, 708, and 712 can each accommodate up to a certain number of minimum-pitch metal traces 736 (typically a lower-level metal, such as metal 1 (M1) or metal 2 (M2)) that route laterally across a standard cell. In the context of standard cells, these metal traces used for routing across standard cells can be called "traces", and a standard cell library can be characterized by the number of tracks the standard cells in that library can accommodate. The layouts of the high-performance, high-density, and ultra-high-density standard cells can accommodate 12, 9, and 7 tracks, respectively. That a standard cell library can accommodate a number of minimum width metal traces does not mean that that number of minimum pitch metal traces are always used for routing signals across the standard cells. For example, in high-performance standard cells, metal traces with greater-than-minimum widths and greater-than-minimum spacings to adjacent traces can be used to reduce parasitic resistance and capacitance.

In some embodiments, the height of the standard cells in a standard cell library is the same for all cells in the library, although in some embodiments, a standard cell library can comprise more complex cells that have a standard cell height that is a multiple of a base standard cell height. When an integrated circuit design is synthesized from an HDL description, the resulting physical design typically comprises standard cells arranged in rows, and a single row comprising multiple standard cells arranged laterally, with the standard cells being connected via input and output signals routed between standard cells. The standard cells in a library can vary in width (e.g., widths 740, 744, 748), with a standard cell width depending on the function being implemented by the standard cell.

FIG. 8 illustrates example physical designs of an inverter standard cell implemented using different transistor types. FIG. 8 illustrates standard cell layouts for an inverter implemented using manufacturing processes that use planar FETs (layout 800) or FinFETs (layout 850), respectively. Layouts 800 and 850 have a height 804, a width 808, and a boundary 812. The layouts 800 and 850 show the n-type and p-type diffusion regions; and gate, contact, and metal 1 (M1) layers. Standard cell layouts may comprise layers in addition to those shown in layouts 800 and 850. The PMOS transistors in the layout 800 have a width 816 and a length 820 and the NMOS transistors in the layout 800 have a width 824 and a width 828. The total PMOS transistor width in the layout 850 of the FinFET inverter is the sum of the widths 832 of the three fins 836 and the total NMOS transistor width in the layout 850 of the FinFET inverter is the sum of the widths 840 of the three fins 844. The PMOS transistors in the layout 850 have a length 834 and the NMOS transistors in the layout 850 have a length 838. Standard cell libraries can comprise other transistor types, such as gate-all-around FETs (GAAFETs).

Layouts 800 and 850 show the M1 traces that provide power (trace 848), ground (trace 852), input (trace 856) and output (trace 860) signals to the transistors. Not shown are metal traces at higher-level metals that route signals to and from standard cells. In a row of logic standard cells, the top and bottom traces can be occupied by metal traces that provide power and ground to the row of standard cells. In some embodiments, these power and ground traces extend along a length of a logic standard cell row, running along the full width of each standard cell in the row.

A logic standard cell library may be characterized and distinguishable from other standard cell libraries by its standard cell height, which can be the distance between the midpoints of the metal traces of the lowest-level metal at the top and bottom of the standard cell that provide power and ground signals to transistor (e.g., traces 848 and 852). A proxy for standard cell height can be, in the case of logic standard cells comprising FinFET transistors, the maximum number of FinFET fins that can be placed along the height of a standard cell (which is six for a standard cell library that comprises an inverter standard cell having the layout 850). While not every logic standard cell in a standard cell library may have the maximum number of FinFET fins that the standard cell height can accommodate, the maximum number of FinFET fins that a standard cell library can accommodate may be discerned through examination of a logic block comprising multiple rows of logic standard cells. Standard cell libraries may further be distinguished by their minimum transistor channel length or other features, as described herein.

Despite the availability of multiple logic standard cell libraries for a single manufacturing process, implementing the multiple transistor types utilized by the different standard cells in a single manufacturing process can have its disadvantages. For example, implementing transistors with different threshold voltages or gate oxide thicknesses in a single manufacturing process can require additional masks and processing steps, making the process more complex and costly, and having transistors with different channel lengths and VTs can increase transistor performance variability. Further, optimizing a manufacturing process to be able to fabricate the various types of transistors used across multiple standard cell families typically involves making tradeoffs. That is, a process adjustment that may improve a performance characteristic of transistors in one standard cell library may result in sacrificing a performance characteristic of transistors in another standard cell library.

To address these concerns, the 3D heterogeneous integration technologies described herein can be used to form an integrated circuit component, with a base die and a die bonded to the base die (bonded die) each utilizing logic standard cells from a single logic standard cell library. The sorting of logic standard cells across dies by standard cell type allows for separate manufacturing processes to be used to fabricate the bonded and base dies, allowing for the separate manufacturing processes to be optimized or tailored for a specific standard cell library independently. The individual manufacturing processes may thus be less expensive (owing to a fewer number of steps) and may result in transistors or standard cells having improved performance characteristics (e.g., higher drive current, lower gate or drain leakage, tighter layout) relative to a manufacturing process developed to implement standard cells from several types of standard cell libraries.

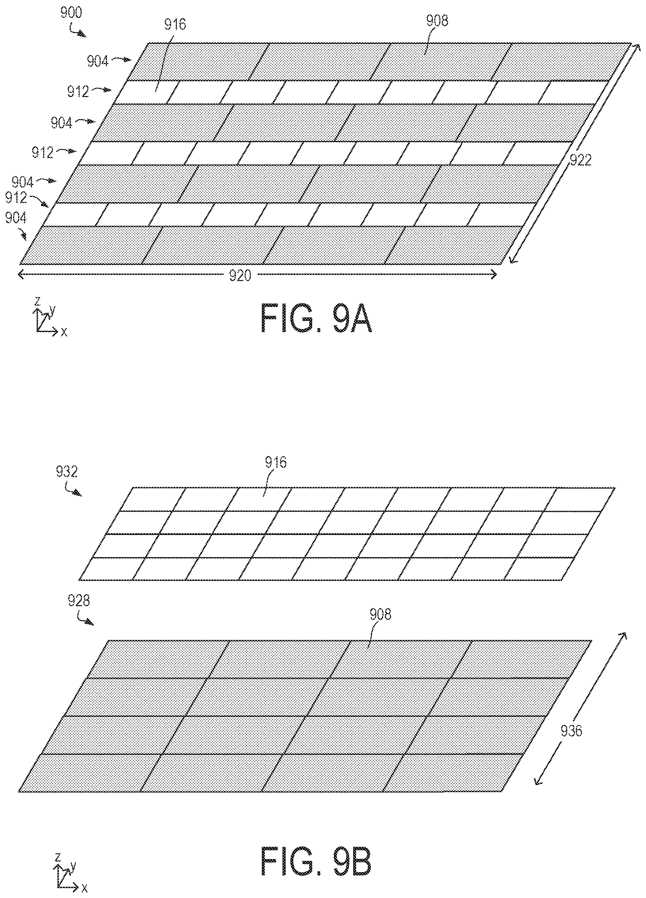

FIGS. 9A-9B illustrates an example division of logic standard cells among a bonded die and a base die in a 3D heterogeneous integrated circuit component. FIG. 9A illustrates an example layout 900 of an integrated circuit design with a hybrid of logic standard cells. The layout 900 comprises seven rows of standard cells, with rows 904 comprising high-performance logic standard cells 908 and rows 912 comprising high-density logic standard cells 916. The layout 900 has an x-dimension 920 and a y-dimension 922. Although all of the high-performance standard cells and all of the high-density standard cells are illustrated as having a common width, as stated previously, standard cells belonging to a particular standard cell library can possess a variety of widths.

FIG. 9B illustrates an example division of the high-performance logic standard cells 908 and the high-density logic standard cells 916 into separate layouts having just one standard cell type. Layout 928 comprises the high-performance logic standard cells 908 and can be implemented in a base die and layout 932 comprises the high-density logic standard cells 916 and can be implemented in a bonded die. Splitting the high-performance and high-density cells across vertically stacked integrated circuit dies can result in an overall lateral area reduction as the high-performance standard cells can be collapsed. For example, the y-dimension 936 of the layout 928 of the high-performance standard cells is less than the y-dimension 922 of the layout 900 comprising both high-performance and high-density standard cells. Additional benefits to splitting high-density and high-performance standard cells across vertically stacked dies include improved performance. This can be due in part to signals routed vertically through the metallization stacks of the bonded and base dies between the high-performance and high-density standard cells traveling shorter distances than the lateral distance signals needed to travel between high-performance and high-density standard cells on a base die implementing both high-performance and high-density standard cells. Additionally, critical paths implemented using high-performance standard cells in the base die may experience performance improvements with high-density standard cells moved to a bonded die due to the high-performance cells being closer to each other.

Although FIGS. 9A and 9B show two standard cells of two different types being split across integrated circuit dies, in other embodiments, standard cells belonging to more than two standard cell library types can be split across multiple dies. For example, in a SoC design utilizing high-performance, high-density, and ultra-high-density standard cells, the base die could be dedicated to high-performance standard cells, one or more chiplets could be dedicated to high-density standard cells, and one or more additional chiplets could be dedicated to the ultra-high-density standard cells. Further, in other embodiments, chiplets comprising logic standard cells of a single type can be stacked in a fashion similar to the stacking of chiplets comprising SRAM and/or DRAM functionality described above. In some stacked chiplet embodiments, all of the chiplets in a stack can utilize standard cells of a single standard cell type. In other embodiments, a chiplet stack can comprise chiplets dedicated to different standard cell types (e.g., a stack can comprise a first chiplet dedicated to high-performance standard cells and a second chiplet dedicated high-density standard cells).

Any of the various standard cell types enabled by a manufacturing process can be implemented in any bonded die or the base die. In some embodiments, the standard cell type having the highest yield can be implemented in the base die. Alternatively, which particular standard cell type is utilized in a base die can be further driven by the design of the integrated circuit component. For example, if a high-performance integrated circuit die is larger and has a better yield than a high-density integrated circuit die, it would be advantageous to use the high-density wafer as the source of the dies in a die-to-wafer bonding scheme.

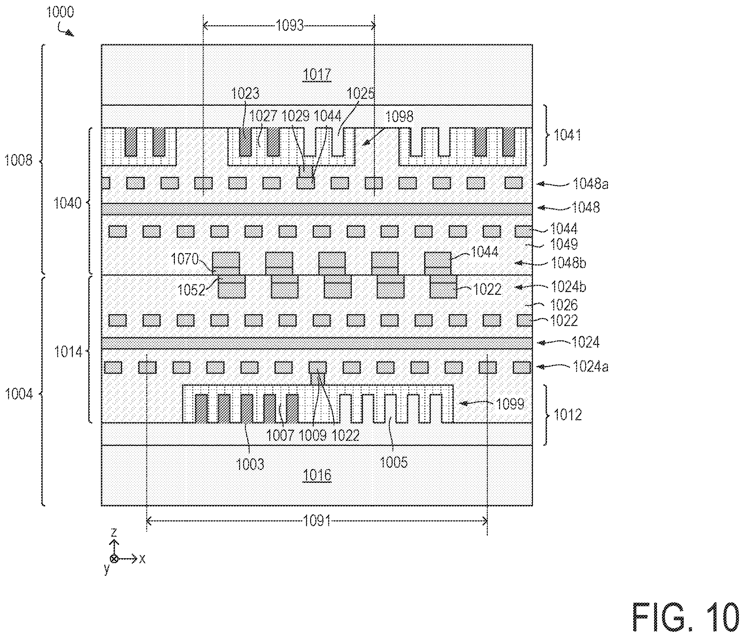

FIG. 10 is a cross-section of a sixth example 3D heterogeneous integrated circuit structure comprising a hybrid of logic standard cells. Structure 1000 comprises a base die 1004 comprising high-performance logic standard cells and an integrated circuit die bonded to the base die 1004 (bonded die 1008) comprising high-density logic standard cells. The base die 1004 comprises a metallization stack 1014, a device layer 1012, and a substrate 1016. The device layer 1012 comprises an inverter standard cell 1099 that comprises a PMOS FinFET transistor that comprises p-type fins 1003, an NMOS FinFET transistor that comprises n-type fins 1005, and a gate 1007 that controls the PMOS and NMOS transistors. The metallization stack 1014 comprises a plurality of interconnect layers, individual of the interconnect layers comprising a dielectric layer 1026 and metal traces 1022 belonging to a metal layer 1024. The gate 1007 is connected to a metal trace 1022 of a bottom-most metal layer 1024a of the metallization stack 1014 by a contact 1009. Metal traces 1022 of a top-most interconnect layer 1024b of the metallization stack 1014 are electrically conductively coupled to pads 1052.

The bonded die 1008 comprises a metallization stack 1040, a device layer 1041, and a substrate 1017. The device layer 1041 comprises an inverter standard cell 1098 that comprises a PMOS FinFET transistor that comprises p-type fins 1023, an NMOS FinFET transistor that comprises n-type fins 1025, and a gate 1027 that controls the PMOS and NMOS transistors. The metallization stack 1040 comprises a plurality of interconnect layers, individual of the interconnect layers comprising a dielectric layer 1049 and metal traces 1044 belonging to a metal layer 1048. The gate 1027 is connected to a metal trace 1044 of a bottom-most metal layer 1048a of the metallization stack 1014 by a contact 1029. Metal traces 1044 of a top-most interconnect layer 1048b of the metallization stack 1040 are electrically conductively coupled to pads 1070. The inverter standard cells 1098 and 1099 are representative cross-sections of a FinFET inverter, such as a cross-section of the layout 850 taken along the line A-A' in FIG. 8.

The base die 1004 is attached to bonded die 1008 by hybrid bonding. The hybrid bond between the base die 1004 and the bonded die 1008 is formed by bonding pads 1052 of the base die 1004 to pads 1070 of the bonded die 1008 and bonding dielectric material located between the pads 1052 to dielectric material located between the pads 1070.

The inverter standard cell 1099 is a high-performance logic standard cell and has a standard cell height 1091 that spans 11 tracks (11 pitches of bottom-most metal layer 1024a). The inverter standard cell 1098 is a high-density logic standard cell and has a standard cell height 1093 that spans 6 tracks (6 pitches of a bottom-most metal layer 1048a). As can be readily seen, standard cell height 1091 is greater than standard cell height 1093. Each of the inverter standard cells 1099 and 1098 can be part of a block of logic that is realized using logic standard cells. As such, each of the inverter standard cells 1099 and 1098 can be located in a row of logic standard cells, having one or more logic standard cells on either or both sides of the inverter standard cell 1099 or 1098, and one or more rows of logic standard cells located above and/or below the row of standard logic cells that comprises inverter standard cell 1099 or 1098.

The use of different standard cell libraries to implement logic on a base die and a bonded die can be manifested by, for example, a difference in the heights of the logic standard cells (e.g., the difference between standard cell heights 1091 and 1093), a difference in the maximum number of FinFET fins placed along the height of a standard cell (e.g., the difference between the total number of fins in the inverter standard cell 1099 and the total number of fins in the inverter standard cell 1098), a difference in minimum transistor channel lengths, a difference in transistor gate oxide thickness, a difference in the metal layer thickness, or in another manner described herein.

Signals can be passed between the logic standard cells in the base die 1004 and the bonded die 1008 through pads 1052 and 1070. The ability to form a fine pitch hybrid bond between the base die 1004 and the bonded die 1008 enables the communication of input and output signals between the high-performance logic standard cells on the base die 1004 and the high-density logic standard cells on the bonded die 1008. In some embodiments, the top-most interconnect layer in the metallization stacks 1014 and 1040 are M4 layers that have a metal pitch in the range of about 40-100 nm. In other embodiments, the top-most interconnect layer in the metallization stack 1014 and 1040 are M4 layers that have a metal pitch in the range of about 40-60 nm. In some embodiments, the hybrid bond between a bonded die and base die can be formed at another suitable metal layer (e.g., M3, M5, M6, M7, M8) having other pitches, such as less than about 140 nm, less than about 120 nm, less than about 100 nm, or less than about 80 nm.

Signals can be passed between a transistor belonging to a logic standard cell on a base die to a transistor located on a bonded die by electrically conductive connections between the transistors. For example, a source or drain of the transistors comprising the inverter standard cell 1099 can be electrically conductively coupled to a gate of the transistors comprising the inverter standard cell 1098. The electrically conductive coupling is provided by a contact, vias, and metal traces of the metallization stack 1014, the pads 1052 and 1070, and metal traces, vias, and a contact of the metallization stack 1040. While FIG. 10 illustrates dies comprising FinFET transistors, in other embodiments, the base die and bonded die can comprise any other type of transistors, such as planar FETs or GAAFETs. And in some embodiments, the base die and bonded die can employ different transistor types (e.g., a high-performance base die can comprise FinFETs or GAAFETs and a high-density bonded die can comprise planar FETs).

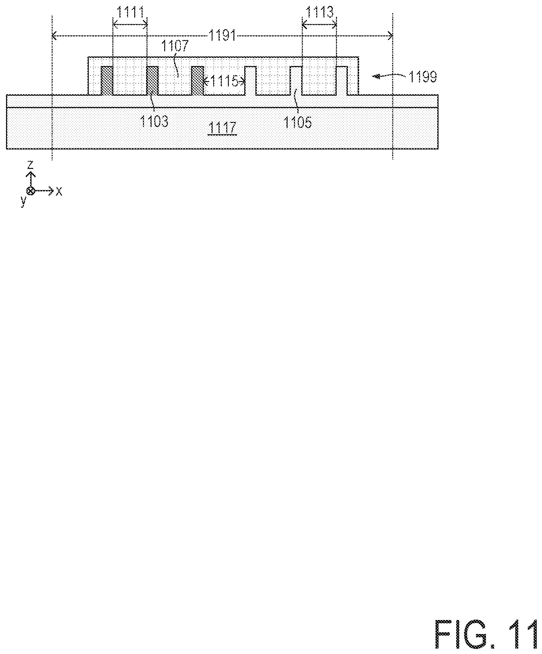

FIG. 11 is a cross-section of an example high-performance inverter standard cell. The inverter standard cell 1199 can be a high-performance inverter located on a substrate 1117 and comprises a PMOS FinFET transistor comprising p-type fins 1103, anNMOS FinFET transistor that comprises n-type fins 1105, and a gate 1107 that controls the PMOS and NMOS transistors. The inverter standard cell 1199 has a height 1191, which is the same as the standard cell height 1091 of inverter standard cell 1099. The inverter standard cell 1199 illustrates that different standard cell libraries can have the same height and differ in other respects. The inverter standard cell 1199 differs from the inverter standard cell 1099 in that it has fewer NMOS and PMOS fins and a spacing between n-type fins (spacing 1111) and p-type fins (spacing 1113). In some embodiments, the spacing between the n-type fin that is nearest the p-type (spacing 1115) can be different between logic standard cell libraries employing FinFETs.

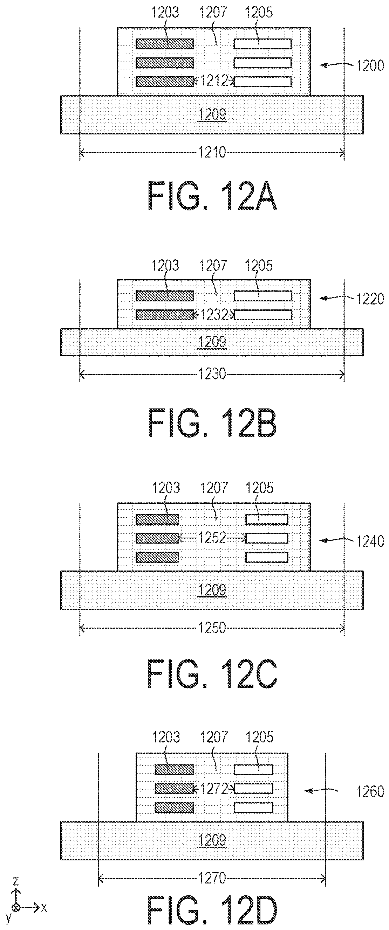

FIGS. 12A-12D illustrate cross-sections of example GAAFET inverter standard cells. As mentioned previously, standard cell libraries can differ in the types of transistors they employ. For example, a high-performance standard cell may employ FinFETs and a high-density cell may employ GAAFETs. FIGS. 12A-12D illustrate how various standard cell libraries comprising GAAFETs could differ. FIGS. 12A-12D illustrate inverter standard cells 1200, 1220, 1240, and 1260 comprising a stack of NMOS GAAFET channel regions 1205, a stack of PMOS GAAFET channel regions 1203, and a gate 1207. The GAAFET inverters are each located on a substrate 1209. The inverter standard cells 1200, 1220, 1240, and 1260 have standard cell heights 1210, 1230, 1250, and 1270, respectively. GAAFET standard cell libraries can differ, for example, in the number of GAAFET channel regions, as illustrated by the difference in inverter standard cell 1200 (three channel regions) and inverter standard cell 1220 (two channel regions) and the width between PMOS and NMOS channel region stacks (channel region stack spacings 1232 and 1252 in inverter standard cells 1220 and 1240 are less than and greater, respectively, than the channel region stack spacing 1212 in inverter standard cell 1200). The standard cell heights 1210, 1230, and 1250 of inverter standard cells 1200, 1220, and 1240, respectively, are the same, illustrating again that standard cell libraries can possess differences other than standard cell height. Inverter standard cell 1260 has the same number of channel regions and a channel region stack spacing 1272 as inverter standard cell 1200. Relative to a standard cell library to which the inverter standard cell 1200 may belong, inverter standard cells 1220, 1240, and 1260, may belong to a low-power standard cell library (due to the lower number of channel regions), a high-performance standard cell library (due to the increased spacing between channel region stacks for reduced parasitic capacitance), and a high-density standard cell library (due to the reduced standard cell height), respectively.

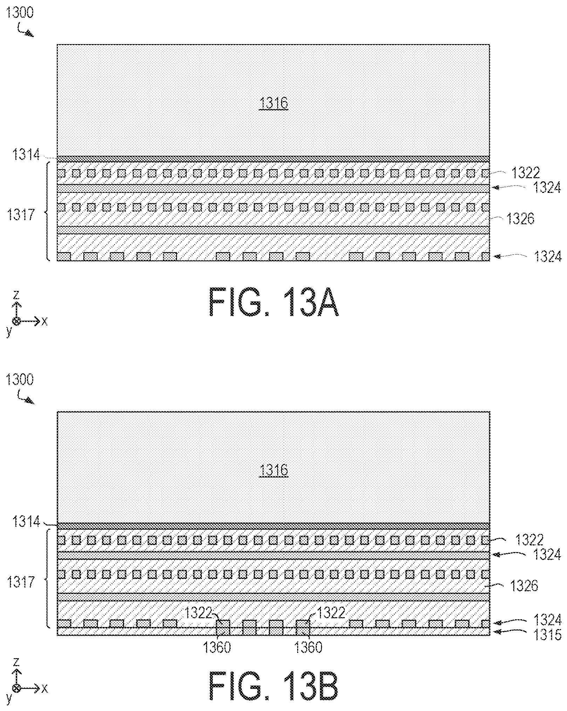

FIGS. 13A-13D illustrate an example sequence of processing steps to fabricate a 3D heterogeneous integrated circuit structure with a chiplet embedded in a frontside metallization stack of a base die. FIG. 13A illustrates an integrated circuit structure (structure 1300) comprising a device layer 1314 comprising transistors. The device layer 1314 is on a substrate 1316. The structure 1300 further comprises a plurality of interconnect layers to form a metallization stack 1317 that comprises metal traces 1322 belonging to metal layers 1324 that are separated by dielectric layers 1326. FIG. 13B illustrates the structure 1300 after formation of a bond pad layer 1315 comprising the pads 1360 that are attached to metal traces 1322 of the top-most interconnect layer of the metallization stack 1317. As mentioned above, the pads 1360 can be directly attached to the metal traces 1322 (as shown) via a damascene process. In other embodiments, the pads 1360 can be attached to the metal traces 1322 by intervening vias. In such embodiments, the pads and vias can be formed by a dual damascene process.

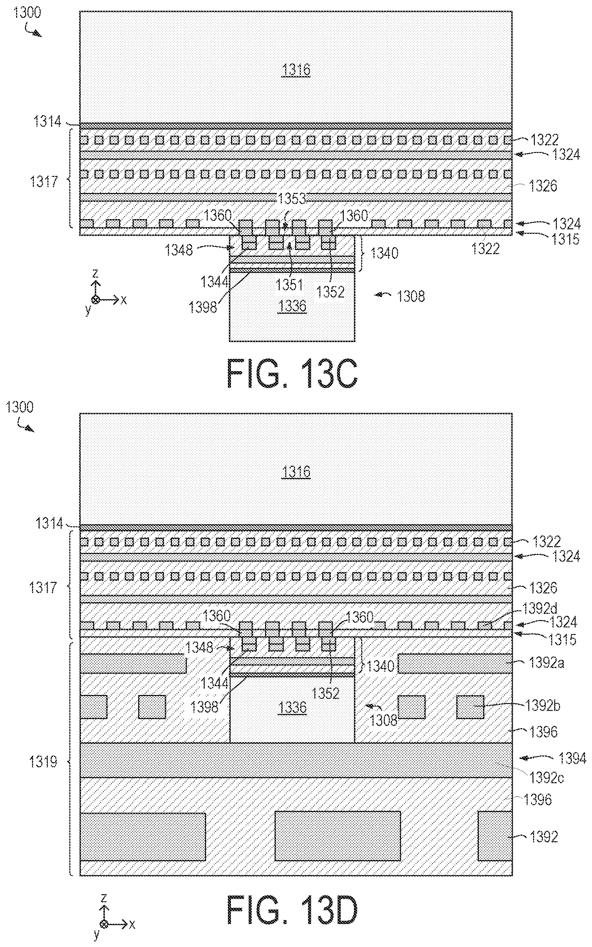

FIG. 13C illustrates the structure 1300 after attachment of a chiplet 1308 to the structure 1300. The chiplet 1308 comprises a substrate 1336, a metallization stack 1340, and a device layer 1398 positioned between the substrate 1336 and the metallization stack 1340. Metal traces 1344 of a top-most layer 1348 of the metallization stack 1340 are electrically conductively coupled to pads 1352. The chiplet 1308 can be attached to the structure 1300 by hybrid bonding. Hybrid bonding of the chiplet 1308 to the base die 1304 comprises bonding the pads 1352 of the chiplet 1308 to the pads 1360 of the base die 1304 and bonding dielectric material 1351 located between the pads 1352 to dielectric material 1353 located between the pads 1360.

In some embodiments, a chiplet stack can be attached to the metallization stack 1317 instead of an individual chiplet (e.g., chiplet 1308). In such embodiments, the chiplet stack may have been formed prior to attachment of the chiplet stack to the metallization stack 1317. Alternatively, the chiplet stack is formed by attaching chiplets sequentially, one at a time, to the metallization stack 1317. For example, after the chiplet 1308 is attached to the metallization stack 1317, the substrate 1336 of the chiplet 1308 can be thinned, through-silicon vias can be formed (by using a via-last TSV process) that extend through the substrate 1336 to connect to metal traces in the metallization stack 1340, and pads are formed on a back side of the chiplet 1308. A second chiplet is then attached to the chiplet 1308 by, for example, hybrid bonding. The processes of substrate thinning, TSV formation, pad formation, and chiplet attach are repeated to realize a chiplet stack of having a desired number of chiplets. In some embodiments, the TSVs are formed in the chiplets during chiplet formation using via-first or via-middle TSV processing approaches, and the TSVs are revealed during chiplet substrate thinning.

Preformed chiplet stacks can be formed using wafer-to-wafer (W2W) bonding approaches and chiplet stacks formed on base die can be formed using chip-to-wafer (C2W) bonding approaches. For individually stacked chiplets, processing artifacts may be visible in a final integrated circuit structure, such as grinding defects or rounding, tapering or other shaping at the chiplet edges (which can aid in the relief of mechanical stresses at the chiplet edges and help avoid chipping, cracking, and fracture propagation). Some Examples of features that may be formed on the edges or corners of chiplets for mechanical stress relief include chamfered or filleted edges or corners. Additionally, in some embodiments, conformal stress relief dielectric layers may be formed on a chiplet to help alleviate mechanical stress. The formation of chiplet stacks prior to attachment of the chiplet stack to a base die can enable faster time-to-market owing to chiplet formation being performed in parallel with base die fabrication up to a metallization stack middle layer.

In yet other embodiments, individual die that are heterogeneous relative to a base die are bonded to a base die at the die or wafer level. In such embodiments, the full interface between the top-most layers of the die being attached to a base die and the base die is hybrid bonded with at least of portion of the bond pads having a fine pitch (e.g., less than about 500 nanometers).

FIG. 13D illustrates the structure 1300 after formation of a plurality of interconnect layers that form a metallization stack 1319 over the metallization stack 1317 and the chiplet 1308. The metallization stack 1319 comprises metal traces 1392 belonging to metal layers 1394 that are separated by dielectric layers 1396. The chiplet 1308 extends through interconnect layers of the metallization stack 1319 that comprises metal traces, such as traces 1392a and 1392b. That is, there can be metal traces in the interconnect layers that laterally surround the chiplet 1308. In other embodiments, the metallization stack 1319 can be formed by performing a blanket deposition that fills the volumes laterally adjacent to the chiplet 1308 with a dielectric material and then performing a planarization step before additional interconnect layers that comprise metal traces are formed in the metallization stack 1319. That is, in some embodiments, the chiplet 1308 is laterally surrounded by a dielectric material that does not comprise metal traces (but that may contain vias to connect traces of interconnect layers covering the chiplet 1308 (e.g., interconnect layer 1392c) to traces (e.g., interconnect layer 1392d) of interconnect layers positioned between the chiplet 1308 (interconnect layers that are part of metallization stack 1317) and the substrate 1316.

In other embodiments, instead of a chiplet attach-blanket deposition-planarization approach, a blanket deposition of dielectric material can be performed before the chiplet is attached. In such embodiments, a sacrificial etch stop layer can be formed over a bonding layer on the base die metallization stack, where a chiplet is to be attached to protect the bonding layer. A blanket deposition of dielectric material is then performed, and the layer of dielectric material is planarized. An etch of the dielectric material layer is then performed where the chiplet is to be attached, the sacrificial etch stop layer is removed, and the chiplet is attached and bonded to the base die.

FIGS. 13A-13D illustrate a process of embedding a chiplet in a frontside metallization stack of an integrated circuit structure (the frontside metallization stack comprising the metallization stacks 1317 and 1319), but in other embodiments, a chiplet may be similarly embedded in a backside metallization stack. In such embodiments, the process for attaching the chiplet to the integrated circuit structure is similar to that illustrated in FIGS. 13A-13D, but with the metallization stacks formed on the opposite side of a substrate from the device layer. In still other embodiments, the chiplet is attached to the top of frontside metallization stack or a backside metallization stack. That is, all of the interconnect layers in the metallization stack are located between the chiplet and the substrate. In such embodiments, high aspect ratio vias can be formed in the metallization stack before attachment of the chiplet to allow for connection between the chiplet and traces at a middle interconnect layer of a base die metallization stack.

Any of the chiplets described herein can comprise alignment markers or fiducials to aid in the bonding of a chiplet to a base die. Alignment markets can be located in one or more corners of a chiplet or any other advantageous position and take any suitable form or shape (e.g., box-in-box, crosshairs). The bonding layer to which chiplets are bonded can also comprise alignment marks to aid in chiplet-to-base die alignment during hybrid bonding. In some embodiments, the alignment markers can be electrically active (e.g., used for power delivery, delivering high-speed signals) to improve the utilization efficiency of the chiplet-base die interface.

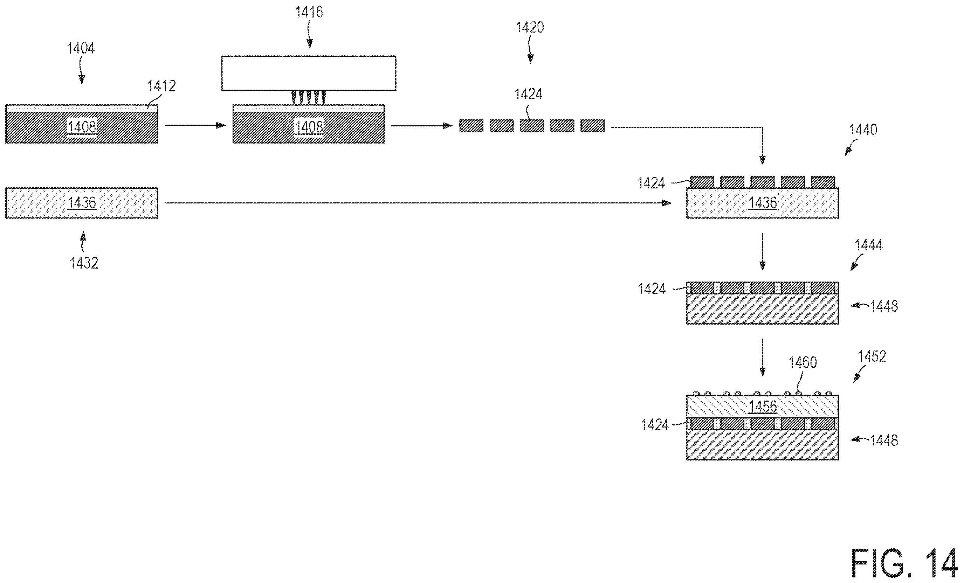

FIG. 14 illustrates an example sequence of processing steps to fabricate a 3D heterogeneous integrated circuit structure with hybrid logic dies. At a stage 1404, a wafer 1408 comprising integrated circuit dies that comprise high-density logic standard cells is fabricated through the formation of a middle metal layer (e.g., M4) of a metallization stack. A sacrificial interconnect layer 1412 is formed on a top surface of the wafer 1408 to enable testing of the dies. At a stage 1416, the dies on the wafer 1408 are tested and sorted to identify known good dies (KGDs). At a stage 1420, the sacrificial interconnect layer 1412 is removed (by, for example, CMP and etch techniques) from the wafer 1408 and the wafer 1408 is singulated. In some embodiments, the wafer 1408 can be thinned before singulation. Known good dies (KGDs 1424) are identified. At a stage 1432, a wafer 1436 comprising integrated circuit dies (base dies) comprising high-performance logic standard cells is fabricated through the formation of a middle metal layer (e.g., M4) of a metallization stack.

At a stage 1440, KGDs 1424 are attached to the wafer 1436 by attaching the top-most interconnect layer in the metallization stack of the KGDs 1424 to the top-most interconnect layer in the base die metallization stack via hybrid bonding. In some embodiments, the pitch of the bonding pads is in the range of about 40-100 nm, which matches the M4 pitch in some advanced manufacturing processes. This fine hybrid bonding pitch enables high-density routing between logic standard cells on the base die wafer and the KGDs 1424. At a stage 1444, the gaps between the KGDs 1424 are filled to form a reconstituted wafer 1448 and the top surface of the reconstituted wafer 1448 is planarized. At a stage 1452, backside processing of the reconstituted wafer 1448 is performed, which comprises forming backside interconnect layers 1456 and forming solder bumps 1460 on a surface of the backside interconnect layers 1456. Through-silicon vias are used to connect the KGDs 1424 to the backside interconnect layers 1456. The resulting wafer can then be tested and singulated.

While FIG. 14 illustrates KGDs being hybrid bonded to a base die in a "face-to-face" (i.e., interconnect-to-u8 interconnect) approach, in other embodiments TSVs can be formed on the backside of the KGDs and the backside of the KGDs can be hybrid bonded to the base die in a "back-to-face" approach. In a variation of these other embodiments, a metallization stack can be formed on the backside of the KGDs with the backside metallization stack connecting to transistor gate and diffusion regions by through-silicon vias that connect the backside metallization stack to the frontside metallization stack.

While FIG. 14 illustrates a process that uses hybrid bonding in a die-to-wafer bonding approach, in other embodiments, integrated circuit dies that each use a specific logic standard cell type can be attached using hybrid bonding in a die-to-die or wafer-to-wafer bonding scheme. Moreover, an integrated circuit die being bonded to a base die in which the two dies each use a specific logic standard cell type, the integrated circuit die being bonded to a base die can be a chiplet. As such, the die being bonded can have a lateral area that is less than the lateral area of a base die and one or more of these chiplets can be hybrid bonded to a base die in accordance with any of the embodiments disclosed herein (e.g., multiple individual chiplets can be bonded to a base die and arranged in any lateral configuration on top of the base die, one or more chiplet stacks can be bonded to the base die (with different chiplets in the stack being dedicated to the same or different standard cell types), one or more chiplets can be embedded within and/or located on top of a frontside or backside metallization stack.)

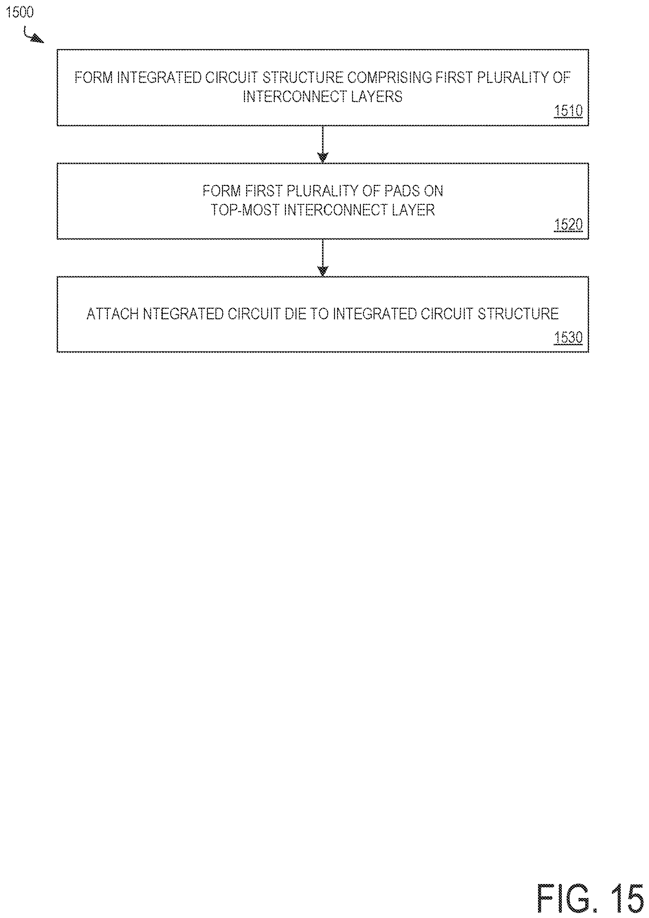

FIG. 15 is an example method of forming a 3D heterogeneous integrated circuit structure. The method 1500 can be performed by an integrated circuit component manufacturer. At a stage 1510 an integrated circuit structure comprising a first plurality of interconnect layers is formed, the first plurality of interconnect layers located on a first substrate comprising silicon. At a stage 1520, a first plurality of pads on a top-most interconnect layer of the first plurality of interconnect layers is formed, the plurality of pads electrically conductively coupled to a plurality of traces of the top-most interconnect layer. At stage 1530, an integrated circuit die is attached to the integrated circuit structure, wherein the integrated circuit die comprises a second plurality of interconnect layers and a second plurality of pads electrically conductively coupled to a top-most interconnect layer of the second plurality of interconnect layers, attaching the integrated circuit die to the integrated circuit structure comprises bonding the first plurality of pads to the second plurality of pads, a pitch of the first plurality of pads is less than about 500 nanometers, and a lateral area of the first substrate is less than a lateral area of the integrated circuit die.

In other embodiments, the method 1500 can comprise one or more additional elements. For example, the method 1500 can further comprise forming a third plurality of interconnect layers over the first plurality of interconnect layers and the integrated circuit die. In another example, the method 1500 can further comprise forming a third plurality of pads electrically conductively coupled to a second plurality of metal traces of the top-most layer of the first plurality of interconnect layers; and attaching a second integrated circuit die comprising a third plurality of interconnect layers and a fourth plurality of pads attached to a top-most layer of the third plurality of interconnect layers, wherein individual pads of the fourth plurality of pads are bonded to a pad of the third plurality of pads, a pitch of the third plurality of pads being less than about 500 nanometers.

In any of the embodiments described herein, a chiplet substrate or base die substrate can comprise any of the materials that comprise die substrate 1702 or any other suitable materials. In any of the embodiments described herein, a trace of a metal layer of an interconnect layer can comprise copper, aluminum, tungsten, cobalt, ruthenium, titanium, nickel, molybdenum, an alloy comprising one or more of these metals, or any other suitable metal. In any of the embodiments, disclosed herein, a dielectric layer between metal layers (an interlayer dielectric (ILD)) or dielectric material between pads can be any suitable nitride or oxide, such as silicon dioxide (SiO₂, which is a material that comprises silicon and oxygen), carbon-doped silicon dioxide (C-doped SiO₂, also known as CDO or organosilicate glass, which is a material that comprises silicon, oxygen, and carbon), fluorine-doped silicon dioxide (F-doped SiO₂, also known as fluorosilicate glass, which is a material that comprises fluorine, silicon, and oxygen), hydrogen-doped silicon dioxide (H-doped SiO₂ which is a material that comprises silicon, oxygen, and hydrogen), and silicon nitride (SiₓN_{y}, which is a material that comprises silicon and nitrogen).

In any of the embodiments described herein, the electrodes of a DRAM capacitor can comprise titanium and nitride (such as titanium nitride, TiN), ruthenium, iridium and oxygen (such as iridium oxide, IrO₂), polysilicon, or any other suitable conductive material, and the dielectric material located between the electrodes in a DRAM bitcell capacitor can comprise materials comprising silicon and oxygen (such as silicon dioxide, SiO₂), silicon and nitrogen (such as silicon nitride (SiₓN_{y}), zirconium and oxygen (such as zirconium dioxide, ZrO₂), titanium and nitrogen (such as titanium nitride, TiN), hafnium and oxygen (such as hafnium dioxide, HfO₂), aluminum and oxygen (aluminum oxide, Al₂O₃), combinations of these materials, or any other suitable insulator. In some embodiments, the DRAM capacitor comprises a ferroelectric material (DRAMs comprise such capacitors can be referred to as FeRAMs) as the insulator, and the dielectric material between the bitcell capacitor electrodes can comprise lead, zirconium, titanium, and oxygen (lead zirconate titanate (PZT), PbZrₓTi₁₋ₓO3); strontium, bismuth, and tantalum (strontium bismuth tantalate (SBT), SrBi₂Ta₂O₉), or any other suitable ferroelectric material.

The 3D heterogeneous integrated circuit components and structures described herein can be used in any processor unit or integrated circuit component described or referenced herein. A 3D heterogeneous integrated circuit component can be attached to a printed circuit board. In some embodiments, one or more additional integrated circuit components or other components, such as a battery or antenna, can be attached to the printed circuit board. In some embodiments, the printed circuit board and the integrated circuit component can be located in a computing device that comprises a housing that encloses the printed circuit board.

It is to be understood that drawings illustrate idealized versions of structure cross-sections. In actual cross-sections, the lines, layers, and other elements illustrated in the drawings can have shapes that vary from those illustrated. For example, surfaces illustrated as planar possess undulations, bumps, or dishing features; sidewalls can have a taper to them; ninety-degree corners can be rounded; fins of FinFet can be tapered and have rounded tops; and lines, layers, and features can overlap more or less than illustrated.

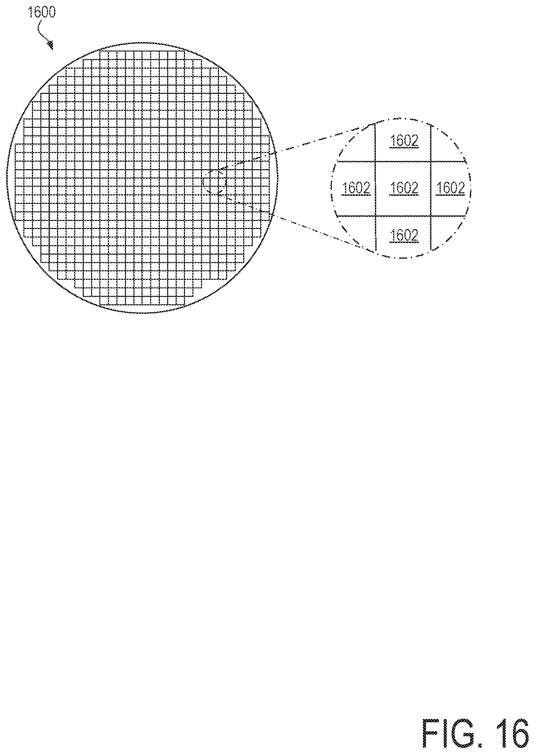

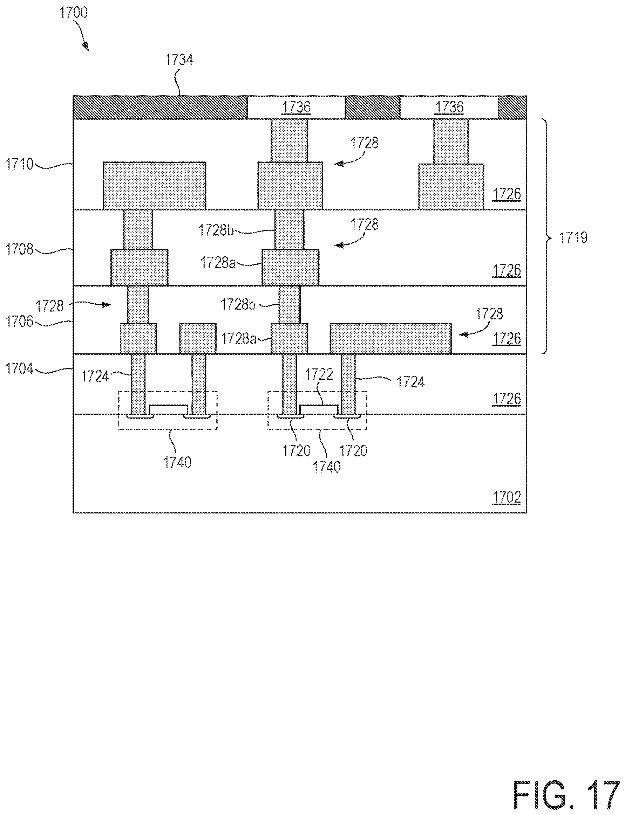

FIG. 16 is a top view of a wafer 1600 and dies 1602 that may be included in any of the microelectronic assemblies of integrated circuit structure disclosed herein (e.g., as any suitable ones of the chiplets 108, 208, 308). The wafer 1600 may be composed of semiconductor material and dies 1602 having integrated circuit structures formed on a surface of the wafer 1600. The individual dies 1602 may be a repeating unit of an integrated circuit product that includes any suitable integrated circuit. After the fabrication of the semiconductor product is complete, the wafer 1600 may undergo a singulation process in which the dies 1602 are separated from one another to provide discrete "chips" of the integrated circuit product. The dies 1602 may be any of the base dies or chiplets. The dies 1602 may include one or more transistors (e.g., transistors 1740 of FIG. 17, discussed below), supporting circuitry to route electrical signals to the transistors, passive components (e.g., signal traces, resistors, capacitors, or inductors), and/or any other integrated circuit components that can be fabricated on the wafer. In some embodiments, the wafer 1600 or the dies 1602 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), logic gates (e.g., AND, OR, NAND, and NOR gates), or any other suitable circuit element. Multiple ones of these devices and components may be combined on a single die. For example, a memory array formed by multiple memory devices may be formed on the same die as a processor unit or other logic configured to store information in the memory devices or execute instructions stored in the memory array. Various ones of the microelectronic assemblies or integrated circuit structures disclosed herein may be manufactured using a die-to-wafer (or chip-to-wafer (C2W)) assembly technique in which chiplets are attached to a wafer 1600 that include base dies, and the wafer 1600 is subsequently singulated.

FIG. 17 is a cross-sectional view of an integrated circuit structure 1700 that may be included in any of the chiplets or base dies described herein. Multiple instances of the integrated circuit structure 1700 may be included in the dies 1602 (FIG. 16). The integrated circuit structure 1700 may be formed on a die substrate 1702. The die substrate 1702 may be a semiconductor substrate composed of semiconductor material including, for example, n-type or p-type materials (or a combination of both). The die substrate 1702 may include, for example, a crystalline substrate formed using bulk silicon or a silicon-on-insulator (SOI) substructure. In some embodiments, the die substrate 1702 can comprise a layer of silicon on top of an SOI layer with bulk silicon below the SOI layer. In some embodiments, the die substrate 1702 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1702. Although a few Examples of materials from which the die substrate 1702 may be formed are described here, any material that may serve as a foundation for an integrated circuit structure 1700 may be used. The die substrate 1702 may be part of a singulated die (e.g., dies 1602 of FIG. 16) or a wafer (e.g., wafer 1600 of FIG. 16).

The integrated circuit structure 1700 may include device layer 1704 disposed on the die substrate 1702. The device layer 1704 may include features of transistors 1740 (e.g., metal oxide semiconductor field-effect transistors (MOSFETs)) formed on the die substrate 1702. The transistors 1740 may include, for example, source and drain regions (S/D regions 1720), a gate 1722 to control current flow between the S/D regions 1720, and S/D contacts 1724 to route electrical signals to and from the S/D regions 1720. The transistors 1740 may include additional features not depicted for the sake of clarity, such as device isolation regions, gate contacts, and the like. The transistors 1740 are not limited to the type and configuration depicted in FIG. 17 and may include a wide variety of other types and configurations such as, for example, non-planar transistors, or a combination of planar and non-planar transistors. Non-planar transistors may include fin field-effect (FinFET) FinFET transistors, such as double-gate transistors or tri-gate transistors, and wrap-around or all-around gate transistors, such as nanoribbon, nanosheet, or nanowire transistors.

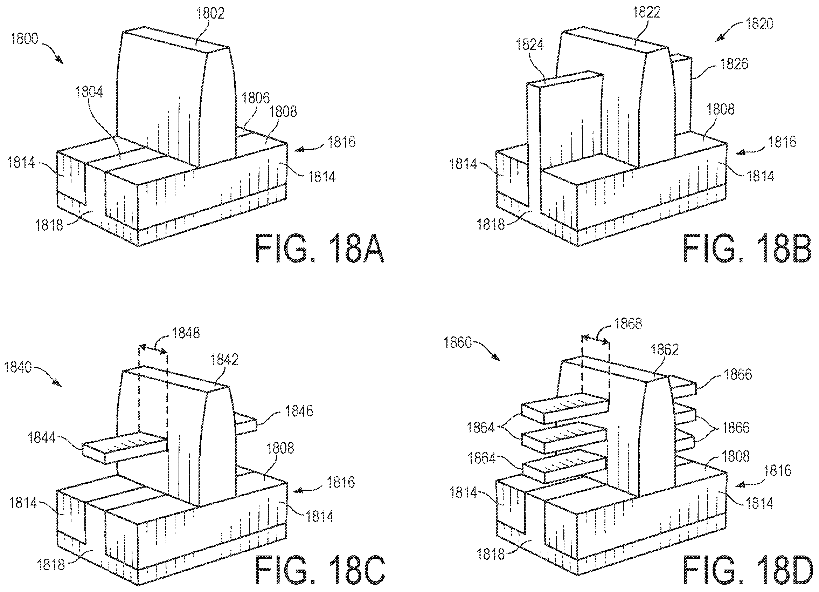

FIGS. 18A-18D are perspective views of example planar, FinFET, gate-all-around, and stacked gate-all-around transistors. The transistors illustrated in FIGS. 18A-18D are formed on a substrate 1816 having a substrate surface 1808 and a bulk region 1818. Isolation regions 1814 separate the source and drain regions of the transistors from other transistors.

FIG. 18A is a perspective view of an example transistor 1800 comprising a gate 1802 that controls current flow between a source region 1804 and a drain region 1806. The transistor 1800 is planar in that the source region 1804, the drain region 1806 and the substrate surface 1808 lie in the same plane.

FIG. 18B is a perspective view of an example transistor 1820 comprising a gate 1822 that controls current flow between a source region 1824 and a drain region 1826. The transistor 1820 is non-planar in that the source region 1824 and the drain region 1826 comprise "fins" that extend upwards from the substrate surface 1808. The transistor 1820 can be referred to as a FinFET. As the gate 1822 encompasses three sides of the fin that extends from the source region 1824 to the drain region 1826, the transistor 1820 can be considered a tri-gate transistor. FIG. 18B illustrates one S/D fin extending through the gate 1822, but multiple S/D fins can extend through the gate of a FinFET transistor.

FIG. 18C is a perspective view of a transistor 1840 comprising a gate 1842 that controls current flow between a source region 1844 and a drain region 1846. The transistor 1840 is non-planar in that the source region 1844 and the drain region 1846 lie in a different plane than the substrate surface 1808. As the gate 1842 encompasses all sides of the channel region of the transistor 1840 that extends from the source region 1844 to the drain region 1846, the transistor 1840 can be referred to as a gate-all-around (GA) transistor.

FIG. 18D is a perspective view of a transistor 1860 comprising a gate 1862 that controls current flow between multiple elevated source regions 1864 and multiple elevated drain regions 1866. The transistor 1860 is a stacked GA transistor as the gate controls the flow of current between multiple elevated S/D regions stacked on top of each other. The transistors 1840 and 1860 are considered gate-all-around transistors as the gates encompass all sides of the channel regions of the transistor that extends from the source regions to the drain regions. The transistors 1840 and 1860 can alternatively be referred to as nanowire, nanosheet, or nanoribbon transistors depending on the width (e.g., widths 1848 and 1868 of transistors 1840 and 1860, respectively) of the channel regions extending through the gate.

Returning to FIG. 17, transistors 1740 may include a gate 1722 formed of at least two layers, a gate dielectric, and a gate electrode. The gate dielectric may include one or more layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For PMOS transistors, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For NMOS transistors, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, such as in the FinFET illustrated in FIG. 18B, the gate electrode may have an upside-down U-shape that includes a top portion substantially parallel to the surface of the die substrate 1702 and two side portions that are substantially perpendicular to the top surface of the die substrate 1702. In other embodiments, such as the planar FET illustrated in FIG. 18A, at least one of the metal layers that form the gate electrode may be a planar layer that is substantially parallel to the top surface of the die substrate 1702 without side portions. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack (comprising the gate dielectric and the gate electrode) to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of sidewall spacer pairs may be used; for instance, two pairs, three pairs, or four pairs of sidewall spacers may be formed on opposing sides of the gate stack.

The S/D regions 1720 may be formed within the die substrate 1702 adjacent to the gate 1722 of transistors 1740. The S/D regions 1720 may be formed using an implantation/diffusion process or an etching/deposition process, for example. In the former process, dopants such as boron, aluminum, antimony, phosphorous, or arsenic may be ion-implanted into the die substrate 1702 to form the S/D regions 1720. An annealing process that activates the dopants and causes them to diffuse further into the die substrate 1702 may follow the ion implantation process. In the latter process, the die substrate 1702 may first be etched to form recesses at the locations of the S/D regions 1720. An epitaxial deposition process may then be carried out to fill the recesses with material that is used to fabricate the S/D regions 1720. In some implementations, the S/D regions 1720 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1720 may be formed using one or more alternate semiconductor materials such as germanium or a group III-V material or alloy. In further embodiments, one or more layers of metal and/or metal alloys may be used to form the S/D regions 1720.

Electrical signals, such as power and/or information-carrying signals (e.g., input/output (I/O) signals, may be routed to and/or from devices (e.g., transistors 1740) of the device layer 1704 through one or more interconnect layers disposed on the device layer 1704 (illustrated in FIG. 17 as interconnect layers 1706-1710). For example, electrically conductive features of the device layer 1704 (e.g., the gate 1722 and the S/D contacts 1724) may be electrically coupled with interconnect structures 1728 of the interconnect layers 1706-1710. The one or more interconnect layers 1706-1710 may form a metallization stack 1719 (which can also be referred to as an "ILD stack" (inter-layer dielectric stack)) of the integrated circuit structure 1700.

The interconnect structures 1728 may be arranged within the interconnect layers 1706-1710 to route electrical signals according to a wide variety of designs; in particular, the arrangement is not limited to the particular configuration of interconnect structures 1728 depicted in FIG. 17. Although a particular number of interconnect layers 1706-1710 is depicted in FIG. 17, embodiments of the present disclosure include integrated circuit structures having more or fewer interconnect layers than depicted.

In some embodiments, the interconnect structures 1728 may include traces or lines 1728a and/or vias 1728b filled with an electrically conductive material such as a metal. The lines 1728a may be arranged to route electrical signals in a direction of a plane that is substantially parallel with a surface of the die substrate 1702 upon which the device layer 1704 is formed. For example, the lines 1728a may route electrical signals in a direction in and out of the page and/or in a direction across the page from the perspective of FIG. 17. The vias 1728b may be arranged to route electrical signals in a direction of a plane that is substantially perpendicular to the surface of the die substrate 1702 upon which the device layer 1704 is formed. In some embodiments, lines 1728a of different interconnect layers 1706-1710 are electrically coupled by vias 1728b.

The interconnect layers 1706-1710 may include a dielectric material 1726 within which the interconnect structures 1728 are disposed, as shown in FIG. 17. In some embodiments, dielectric material 1726 in different ones of the interconnect layers 1706-1710 may have different compositions; in other embodiments, the composition of the dielectric material 1726 between different interconnect layers 1706-1710 may be the same. The device layer 1704 may include a dielectric material 1726 within which the transistors 1740 are disposed and upon which a bottom layer of the metallization stack is located. The dielectric material 1726 that is part of the device layer 1704 may have a different composition than the dielectric material 1726 included in the interconnect layers 1706-1710; in other embodiments, the composition of the dielectric material 1726 in the device layer 1704 may be the same as a dielectric material 1726 included in any one of the interconnect layers 1706-1710.

A first interconnect layer 1706 (which can be referred to as a Metal 1 or "M1" layer) may be formed directly on the device layer 1704. In some embodiments, the first interconnect layer 1706 may include lines 1728a and/or vias 1728b, as shown. The lines 1728a of the first interconnect layer 1706 may be coupled with contacts (e.g., the S/D contacts 1724) of the device layer 1704. The vias 1728b of the first interconnect layer 1706 may be coupled with the lines 1728a of a second interconnect layer 1708.

The second interconnect layer 1708 (which can be referred to as a Metal 2 or "M2" layer) may be formed directly on the first interconnect layer 1706. In some embodiments, the second interconnect layer 1708 may include vias 1728b to couple the lines 1728a of the second interconnect layer 1708 with the lines 1728a of a third interconnect layer 1710. Although the lines 1728a and the vias 1728b are structurally delineated with a line within individual interconnect layers for the sake of clarity, the lines 1728a and the vias 1728b may be structurally and/or materially contiguous (e.g., simultaneously filled during a dual-damascene process) in some embodiments.

The third interconnect layer 1710 (which can be referred to as a Metal 3 or "M3" layer) (and additional interconnect layers, as desired) may be formed in succession on the second interconnect layer 1708 according to similar techniques and configurations described in connection with the second interconnect layer 1708 or the first interconnect layer 1706. In some embodiments, the interconnect layers that are "higher up" in the metallization stack 1719 in the integrated circuit structure 1700 (i.e., farther away from the device layer 1704) may be thicker than the interconnect layers that are lower in the metallization stack 1719, with lines 1728a and vias 1728b in the higher interconnect layers being thicker than those in the lower interconnect layers.

The integrated circuit structure 1700 may include a solder resist material 1734 (e.g., polyimide or similar material) and conductive contacts 1736 formed on the stack of interconnect layers 1706-1710. In FIG. 17, the conductive contacts 1736 are illustrated as taking the form of bond pads for use in hybrid bonding. The conductive contacts 1736 may be electrically coupled with interconnect structures 1728 of the top-most layer in the metallization stack 1719 and configured to route electrical signals between the transistors 1740 and components external to the integrated circuit structure 1700. For example, solder bonds may be formed on the conductive contacts 1736 to mechanically and/or electrically couple an integrated circuit component comprising the integrated circuit structure 1700 with another component (e.g., a printed circuit board). The integrated circuit structure 1700 may include additional or alternate structures to route electrical signals from the interconnect layers 1706-1710; for example, the conductive contacts 1736 may include other analogous features (e.g., posts) that can route the electrical signals between the transistors 1740 and external components. The conductive contacts 1736 may serve as bonding pads (e.g., pads 152, 160), as appropriate.

In some embodiments in which the integrated circuit structure 1700 is part of a double-sided die (e.g., like the base die 104) the integrated circuit structure 1700 may include a second metallization stack (not shown) located on the opposite side of the die substrate 1702 from the device layer 1704. This second metallization stack may include multiple interconnect layers as discussed above with reference to the interconnect layers 1706-1710. Through-silicon vias (TSVs) that extend through the die substrate 1702 can provide electrically conductive pathways from the transistors 1740 to the second metallization stack and the second metallizaton stack can electrically couple the TSVs to additional conductive contacts (not shown) located on the opposite side of the integrated circuit structure 1700 from the conductive contacts 1736. These additional conductive contacts may serve as bonding pads (e.g., pads 196), as appropriate.

In some embodiments, TSVs extending through the die substrate 1702 can be used for routing power and ground signals from conductive contacts located on the opposite side of the integrated circuit structure 1700 from the conductive contacts 1736 to the transistors 1740 and any other components integrated into the integrated circuit structure 1700, and the metallization stack 1719 can be used to route information-carrying signals from the conductive contacts 1736 to transistors 1740 and any other components integrated into the integrated circuit structure 1700. Put another way, the routing of power and ground signals to the transistors 1740 can be separated (via a backside or bottom-side metallizaton stack and TSVs) from the routing of information-carrying signals to the transistors. The power and ground signals are provided by a backside or bottom-side metallization stack and TSVs, and information-carrying signals are provided by a topside metallization stack (e.g., metallization stack 1719).

Several integrated circuit dies may be stacked with one or more TSVs in the individual stacked dies providing connection between one of the dies to any of the other dies in the stack. For example, one or more high-bandwidth memory (HBM) integrated circuit dies can be stacked on top of a base integrated circuit die and TSVs in the HBM dies can provide connection between the individual HBM dies and the base integrated circuit die. Conductive contacts can provide additional connections between adjacent integrated circuit dies in the stack. In some embodiments, the conductive contacts can be fine-pitch solder bumps (microbumps).

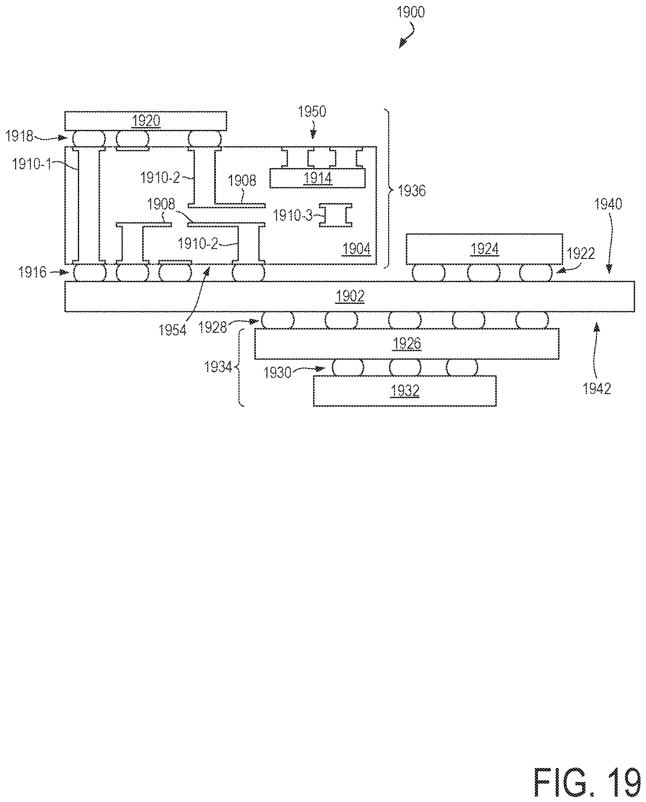

FIG. 19 is a cross-sectional view of an integrated circuit device assembly 1900 that may include any of the microelectronic assemblies or integrated circuit structures disclosed herein. The integrated circuit device assembly 1900 includes a number of components disposed on a circuit board 1902 (which may be a motherboard, system board, mainboard, etc.). The integrated circuit device assembly 1900 includes components disposed on a first face 1940 of the circuit board 1902 and a second face 1942 of the circuit board 1902, the second face 1942 opposing the first face 1940. Generally, components may be disposed on either or both of the first face 1940 and the second face 1942 of the circuit board 1902. Any of the integrated circuit components discussed below with reference to the integrated circuit device assembly 1900 may take the form of any suitable ones of the embodiments of the microelectronic assemblies or integrated circuit structures disclosed herein.

In some embodiments, the circuit board 1902 may be a printed circuit board (PCB) including multiple metal (or interconnect) layers separated from one another by layers of dielectric material and interconnected by electrically conductive vias. The individual metal layers comprise conductive traces. The metal layers may be formed in a desired pattern to route electrical signals between the components electrically coupled to the circuit board 1902. In other embodiments, the circuit board 1902 may be a non-PCB substrate.

The integrated circuit device assembly 1900 illustrated in FIG. 19 includes a package-on-interposer structure 1936 coupled to the first face 1940 of the circuit board 1902 by coupling components 1916. The coupling components 1916 may electrically and mechanically couple the package-on-interposer structure 1936 to the circuit board 1902 and may include solder balls (as shown in FIG. 19), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. (Thus, a coupling component may comprise a conductive contact.)

The package-on-interposer structure 1936 may include an integrated circuit component 1920 coupled to an interposer 1904. The interposer 1904 may provide an intervening substrate used to bridge the circuit board 1902 and the integrated circuit component 1920. The integrated circuit component 1920 is coupled to the interposer 1904 by coupling components 1918. The coupling components 1918 may take any suitable form, such as the forms discussed above with reference to the coupling components 1916. Although FIG. 19 shows just one integrated circuit component attached to the interposer, multiple integrated circuit components may be coupled to the interposer 1904. Additional interposers may be coupled to the interposer 1904.

The integrated circuit component 1920 may be a packaged or unpacked integrated circuit product that includes one or more integrated circuit dies (e.g., the die 1602 of FIG. 16, a die comprising the integrated circuit structure 1700 of FIG. 17) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one unpackaged example of an integrated circuit component 1920, a single monolithic integrated circuit die comprises solder bumps attached to contacts on the die. The solder bumps allow the die to be directly attached to the interposer 1904. The integrated circuit component 1920 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1920 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1920 comprises multiple integrated circuit dies, the dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1920 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1904 may spread connections to a wider or narrower pitch or reroute a connection to a different connection. For example, the interposer 1904 may couple coupling components 1918 having a first pitch to coupling components 1916 having a wider pitch than the first pitch. In the embodiment illustrated in FIG. 19, the integrated circuit component 1920 and the circuit board 1902 are attached to opposing sides of the interposer 1904. In other embodiments, the integrated circuit component 1920 and the circuit board 1902 may be attached to a same side of the interposer 1904. In some embodiments, three or more components may be interconnected by way of the interposer 1904.

In some embodiments, the interposer 1904 may be formed as a PCB, including multiple metal layers separated from one another by layers of dielectric material and interconnected by electrically conductive vias. In some embodiments, the interposer 1904 may be formed of an epoxy resin, a fiberglass-reinforced epoxy resin, an epoxy resin with inorganic fillers, a ceramic material, or a polymer material such as polyimide. In some embodiments, the interposer 1904 may be formed of alternate rigid or flexible materials that may include the same materials described above for use in a semiconductor substrate, such as silicon, germanium, and other group III-V and group IV materials. The interposer 1904 may include metal interconnects 1908 and vias, including but not limited to through hole vias 1910-1 (that extend from a first face 1950 of the interposer 1904 to a second face 1954 of the interposer 1904), blind vias 1910-2 (that extend from the first face 1950 or the second face 1954 of the interposer 1904 to an internal metal layer), and buried vias 1910-3 (that connect internal metal layers).

In some embodiments, the interposer 1904 can comprise a silicon interposer. Through silicon vias (TSV) extending through the silicon interposer can connect connections on a first face of a silicon interposer to an opposing second face of the silicon interposer. In some embodiments, an interposer 1904 comprising a silicon interposer can further comprise one or more routing layers to route connections on a first face of the interposer 1904 to an opposing second face of the interposer 1904.

In some embodiments the interposer 1904, as well as the circuit board 1902, can comprise an amorphous solid layer of glass (which can be referred to a glass core or glass substrate). In some embodiments, the layer of glass can comprise silica (comprising silicon dioxide (SiO₂)), fused silica, aluminosilicate (comprising aluminum oxide (Al₂O₃) and silicon dioxide), borosilicate (comprising silicon dioxide and boron trioxide (B₂O₃)), or alumino-borosilicate (comprising aluminum oxide, silicon dioxide, and boron trioxide). In some embodiments, the layer of glass can comprise one or more of the following additives: aluminum oxide, boron trioxide, magnesium oxide (MgO), calcium oxide (CaO), strontium oxide (SrO), barium oxide (BaO), tin(IV) oxide (SnO₂), nitrous oxide (Na₂O), potassium oxide (K₂O), diphosphorous trioxide (P₂O₃), zirconium dioxide (ZrO₂), lithium oxide (Li₂O), titanium, and zinc. In some embodiments, the layer of glass can comprise silicon and oxygen, as well as one or more of aluminum, boron, magnesium, calcium, barium, tin, sodium, potassium, strontium, phosphorous, zirconium, lithium, titanium, and zinc. In some embodiments, the layer of glass comprises at least 23 percent silicon by weight, at least 26 percent oxygen by weight, and at least five percent aluminum by weight. In some embodiments, the layer of glass does not include an organic adhesive or an organic material. For example, the layer of glass is not a substrate or a board comprising glass fibers and an epoxy binder, such as a printed circuit board (PCB) comprising multiple metal (or interconnect) layers separated from one another by layers of dielectric material (e.g., FR-4 or other fiberglass-reinforced epoxy laminate) and interconnected by electrically conductive vias.

In some embodiments, the glass layer has a thickness in the range of about 50 microns to about 1.4 millimeters. In some embodiments, the glass layer is or is part of a multi-layer glass substrate (a coreless substrate). Individual glass layers in a multi-layer glass substrate can have a thickness in the range of about 25 microns to about 50 microns. In some embodiments, a glass layer can have a length in the range of about 10 millimeters to about 250 millimeters on a side (e.g., can have an area in the range of about 10 mm x 10 mm to about 250 mm x 250 mm). In some embodiments, the glass layer comprises a rectangular prism volume with sections or portions (e.g., through-glass vias) removed and filled with other metals (e.g., metal).

In some embodiments, redistribution layers (RDL) can be located on either or both sides of the glass layer to provide electrically conductive paths from top and/or bottom surfaces of the interposer 1904 or circuit board 1902 to the glass layer. The glass layer can comprise through-glass vias (TGVs) that extend through the glass layer to provide electrically conductive paths through the glass core, glass substrate, or glass layer.

The interposer 1904 may further include embedded devices 1914, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1904. The package-on-interposer structure 1936 may take the form of any of the package-on-interposer structures known in the art.

The integrated circuit device assembly 1900 may include an integrated circuit component 1924 coupled to the first face 1940 of the circuit board 1902 by coupling components 1922. The coupling components 1922 may take the form of any of the embodiments discussed above with reference to the coupling components 1916, and the integrated circuit component 1924 may take the form of any of the embodiments discussed above with reference to the integrated circuit component 1920.

The integrated circuit device assembly 1900 illustrated in FIG. 19 further includes a package-on-package structure 1934 coupled to the second face 1942 of the circuit board 1902 by coupling components 1928. The package-on-package structure 1934 may include an integrated circuit component 1926 and an integrated circuit component 1932 coupled together by coupling components 1930 such that the integrated circuit component 1926 is disposed between the circuit board 1902 and the integrated circuit component 1932. The coupling components 1928 and 1930 may take the form of any of the embodiments of the coupling components 1916 discussed above, and the integrated circuit components 1926 and 1932 may take the form of any of the embodiments of the integrated circuit component 1920 discussed above. The package-on-package structure 1934 may be configured in accordance with any of the package-on-package structures known in the art.

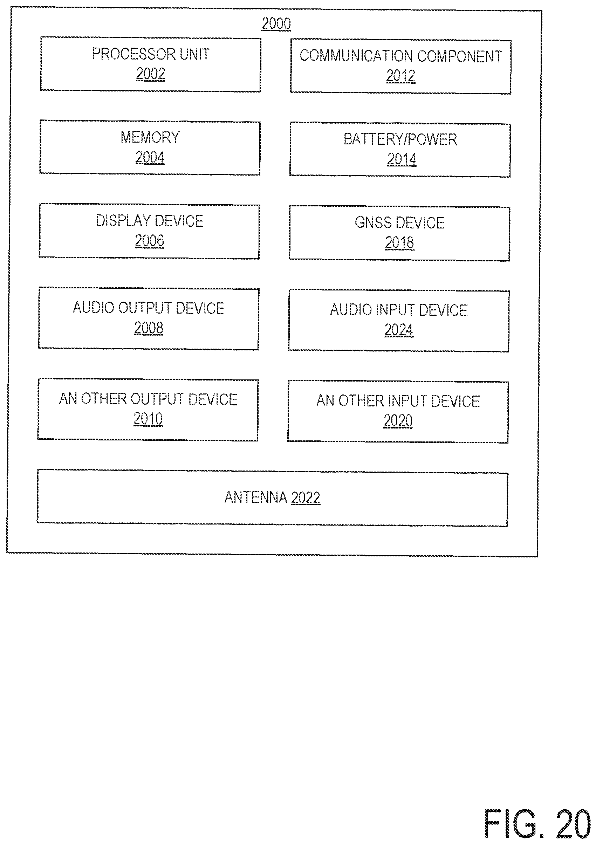

FIG. 20 is a block diagram of an example electrical device 2000 that may include any of the microelectronic assemblies or integrated circuit structures disclosed herein. For example, any suitable ones of the components of the electrical device 2000 may include one or more of the integrated circuit device assembly 1900, integrated circuit component 1920, or integrated circuit structure 1700, integrated circuit dies 1602 disclosed herein, and may be arranged or part of any of the integrated circuit structures disclosed herein. A number of components are illustrated in FIG. 20 as included in the electrical device 2000, but any one or more of these components may be omitted or duplicated, as suitable for the application. In some embodiments, some or all of the components included in the electrical device 2000 may be attached to one or more motherboards mainboards, or system boards. In some embodiments, one or more of these components are fabricated onto a single system-on-a-chip (SoC) die.

Additionally, in various embodiments, the electrical device 2000 may not include one or more of the components illustrated in FIG. 20, but the electrical device 2000 may include interface circuitry for coupling to the one or more components. For example, the electrical device 2000 may not include a display device 2006, but may include display device interface circuitry (e.g., a connector and driver circuitry) to which a display device 2006 may be coupled. In another set of examples, the electrical device 2000 may not include an audio input device 2024 or an audio output device 2008, but may include audio input or output device interface circuitry (e.g., connectors and supporting circuitry) to which an audio input device 2024 or audio output device 2008 may be coupled.

The electrical device 2000 may include one or more processor units 2002. As used herein, the terms "processor unit," "processing unit," or "processor" may refer to any device or portion of a device that processes electronic data from registers and/or memory to transform that electronic data into other electronic data that may be stored in registers and/or memory. The one or more processor units 2002 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 2000 may include a memory 2004, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 2004 may include memory that is located on the same integrated circuit die as the one or more processor units 2002. This memory may be used as cache memory (e.g., Level 1 (L1), Level 2 (L2), Level 3 (L3), Level 4 (L4), Last Level Cache (LLC)) and may include embedded dynamic random-access memory (eDRAM) or spin transfer torque magnetic random-access memory (STT-MRAM).

In some embodiments of the electrical device 2000, a first one of the one or more processor units 2002 can be heterogeneous or asymmetric to a second one of the one or more processor units 2002 in the electrical device 2000. There can be a variety of differences between the one or more processor units 2002 in a system in terms of a spectrum of metrics of merit including architectural, microarchitectural, thermal, power consumption characteristics, and the like. These differences can effectively manifest themselves as asymmetry and heterogeneity among the one or more processor units 2002 in the electrical device 2000.

In some embodiments, the electrical device 2000 may include a communication component 2012. For example, the communication component 2012 can manage wireless communications for the transfer of data to and from the electrical device 2000. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 2012 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 2012 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 2012 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 2012 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 2012 may operate in accordance with other wireless protocols in other embodiments. The electrical device 2000 may include an antenna 2022 to facilitate wireless communications and/or to receive other wireless communications (such as AM or FM radio transmissions).

In some embodiments, the communication component 2012 may manage wired communications, such as electrical, optical, or any other suitable communication protocols (e.g., IEEE 802.3 Ethernet standards). In some embodiments, the electrical device 2000 comprises multiple communication components. For instance, a first communication component may be dedicated to shorter-range wireless communications such as Wi-Fi or Bluetooth, and a second communication component may be dedicated to longer-range wireless communications such as global positioning system (GPS), EDGE, GPRS, CDMA, WiMAX, LTE, EV-DO, or others. In some embodiments, a first communication component may be dedicated to wireless communications, and a second communication component may be dedicated to wired communications.

The electrical device 2000 may include battery/power circuitry 2014. The battery/power circuitry 2014 may include one or more energy storage devices (e.g., batteries or capacitors) and/or circuitry for coupling components of the electrical device 2000 to an energy source separate from the electrical device 2000 (e.g., AC line power).

The electrical device 2000 may include a display device 2006 (or corresponding interface circuitry, as discussed above). The display device 2006 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 2000 may include an audio output device 2008 (or corresponding interface circuitry, as discussed above). The audio output device 2008 may include any embedded or wired or wirelessly connected external device that generates an audible indicator, such as speakers, headsets, or earbuds.

The electrical device 2000 may include an audio input device 2024 (or corresponding interface circuitry, as discussed above). The audio input device 2024 may include any embedded or wired or wirelessly connected device that generates a signal representative of a sound, such as microphones, microphone arrays, or digital instruments (e.g., instruments having a musical instrument digital interface (MIDI) output). The electrical device 2000 may include a Global Navigation Satellite System device (GNSS) (or corresponding interface circuitry, as discussed above), such as a Global Positioning System (GPS) device. The GNSS device 2018 may be in communication with a satellite-based system and may determine a geolocation of the electrical device 2000 based on information received from one or more GNSS satellites, as known in the art.

The electrical device 2000 may include another output device 2010 (or corresponding interface circuitry, as discussed above). Examples of the other output device 2010 may include an audio codec, a video codec, a printer, a wired or wireless transmitter for providing information to other devices, or an additional storage device.

The electrical device 2000 may include another input device 2020 (or corresponding interface circuitry, as discussed above). Examples of the other input device 2020 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 2000 may have any form factor, such as a hand-held or mobile electrical device (e.g., a cell phone, a smartphone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console), a desktop electrical device, a server, a rack-level computing solution (e.g., blade, tray, or sled computing system), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 2000 may be any other electronic device that processes data. In some embodiments, the electrical device 2000 may comprise multiple discrete physical components. Given the range of devices that the electrical device 2000 can be manifested as in various embodiments, in some embodiments, the electrical device 2000 can be referred to as a computing device or a computing system.

As used herein, the term "connected" may indicate elements are in direct physical or electrical contact with each other and the term "coupled" may indicate elements cooperate or interact with each other, but they may or may not be in direct physical or electrical contact. Furthermore, the terms "comprising," "including," "having," and the like, as used with respect to embodiments of the present disclosure, are synonymous. Terms modified by the word "substantially" include arrangements, orientations, spacings, or positions that vary slightly from the meaning of the unmodified term. For example, layers, faces, or features that are referred to as being substantially parallel can refer to layers, faces, or features that are within a few degrees of being parallel with each other; layers, faces, or features that are referred to as being substantially perpendicular or orthogonal to each other can refer to features that are within +/- 15 degrees of being perpendicular or orthogonal to each other. As used herein, the term "about" in reference to a value of a feature (e.g., height, width, spacing) or upper and lower limits of a range of values for a feature includes features values that are within several percent of the stated feature value, feature value lower range limit, or feature value upper range limit.

As used herein, the phrase "located on" or "on" in the context of a first layer or component located on or on a second layer or component refers to the first layer or component being directly physically attached to the second part or component (no layers or components between the first and second layers or components) or physically attached to the second layer or component with one or more intervening layers or components. For example, with reference to FIG. 1, the frontside metallization stack 118 is located on the substrate 116 (with an intervening device layer). A first layer or component that is recited as being located on a second layer or component can be above or below the second layer or component. As used herein, the term "adjacent" refers to layers or components that are arranged next to each other (e.g., side-by-side, top and bottom).

Certain terminology may also be used herein for the purpose of reference only, and thus are not intended to be limiting. For example, terms such as "upper," "lower," "above," "below," "bottom," and "top" refer to directions in the Figures to which reference is made. Terms such as "front," "back," "rear," and "side" describe the orientation and/or location of layers, components, portions of components, etc., within a consistent but arbitrary frame of reference, which is made clear by reference to the text and the associated Figures describing the layers, component, portions of components, etc. under discussion. Such terminology may include the words specifically mentioned above, derivatives thereof, and words of similar import.

As used herein, the term "integrated circuit component" refers to a packaged or unpacked integrated circuit product. A packaged integrated circuit component comprises one or more integrated circuit dies mounted on a package substrate with the integrated circuit dies and package substrate encapsulated in a casing material, such as a metal, plastic, glass, or ceramic. In one example, a packaged integrated circuit component contains one or more processor units mounted on a substrate with an exterior surface of the substrate comprising a solder ball grid array (BGA). In one example of an unpackaged integrated circuit component, a single monolithic integrated circuit die comprises solder bumps attached to contacts on the die. The solder bumps allow the die to be directly attached to a printed circuit board. An integrated circuit component can comprise one or more of any computing system component described or referenced herein or any other computing system component, such as a processor unit (e.g., system-on-a-chip (SoC), processor core, graphics processor unit (GPU), accelerator, chipset processor), I/O controller, memory, or network interface controller.

As used herein, the phrase "electrically conductively coupled" refers to the presence of one or more electrically conductive paths (which can comprise one or more metal traces, one or more vias, etc.) between components that are recited as being electrically coupled.

As used in this application and the claims, a list of items joined by the term "and/or" can mean any combination of the listed items. For example, the phrase "A, B, and/or C" can mean A; B; C; A and B; A and C; B and C; or A, B and C. As used in this application and the claims, a list of items joined by the term "at least one of" can mean any combination of the listed terms. For example, the phrase "at least one of A, B, or C" can mean A; B; C; A and B; A and C; B and C; or A, B, and C. Further, as used in this application and the claims, a list of items joined by the term "one or more of" can mean any combination of the listed terms. For example, the phrase "one or more of A, B, and C" can mean A; B; C; A and B; A and C; B and C; or A, B, and C. Moreover, as used in this application and the claims, a list of items joined by the term "one of" can mean any one of the listed terms. For example, the phrase "one of A, B, or C" can mean A, B, or C.

As used in this application and the claims, the phrase "individual of" or "respective of" following by a list of items recited or stated as having a trait, feature, etc. means that all of the items in the list possess the stated or recited trait, feature, etc. For example, the phrase "individual of A, B, or C, comprise a sidewall" or "respective of A, B, or C, comprise a sidewall" means that A comprises a sidewall, B comprises sidewall, and C comprises a sidewall.

The disclosed methods, apparatuses, and systems are not to be construed as limiting in any way. Instead, the present disclosure is directed toward all novel and nonobvious features and aspects of the various disclosed embodiments, alone and in various combinations and subcombinations with one another. The disclosed methods, apparatuses, and systems are not limited to any specific aspect or feature or combination thereof, nor do the disclosed embodiments require that any one or more specific advantages be present or problems be solved.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

Although the operations of some of the disclosed methods are described in a particular, sequential order for convenient presentation, it is to be understood that this manner of description encompasses rearrangement, unless a particular ordering is required by specific language set forth herein. For example, operations described sequentially may in some cases be rearranged or performed concurrently. Moreover, for the sake of simplicity, the attached figures may not show the various ways in which the disclosed methods can be used in conjunction with other methods.

The following examples pertain to additional embodiments of technologies disclosed herein.

Example A1 comprises an apparatus, comprising: a first integrated circuit die comprising: a first substrate comprising silicon; a first plurality of interconnect layers located on the first substrate; and a first plurality of pads electrically conductively coupled to a first plurality of traces of the first plurality of interconnect layers; and a second integrated circuit die comprising: a second substrate comprising silicon; a second plurality of interconnect layers located on the second substrate; and a second plurality of pads electrically conductively coupled to a second plurality of traces of the second plurality of interconnect layers, wherein individual pads of the first plurality of pads are attached to a pad of the second plurality of pads, a pitch of the first plurality of pads is less than about 500 nanometers, a lateral area of the second integrated circuit die is less than a lateral area of the first integrated circuit die, and individual of the first plurality of pads and individual of the second plurality of pads comprise a metal.

Example A2 comprises the apparatus of Example A1, wherein the first integrated circuit die comprises a substrate and the plurality of interconnect layers is a frontside metallization stack.

Example A3 comprises the apparatus of Example A1, wherein the first integrated circuit die comprises a substrate and the plurality of interconnect layers is a backside metallization stack.

Example A4 comprises the apparatus of any one of Examples A1-A3, wherein the second integrated circuit die further comprises a third plurality of interconnect layers, the second substrate positioned between the second plurality of interconnect layers and the third plurality of interconnect layers.

Example A5 comprises the apparatus of any one of Examples A1-A4, wherein: the first plurality of traces belong to a first interconnect layer of the first plurality of interconnect layers; and the first plurality of pads electrically conductively coupled to the first plurality of traces by a plurality of vias that extend through one or more second interconnect layers of the first plurality of interconnect layers, individual of the plurality of vias extending from one of the first plurality of pads to one of the first plurality of traces.

Example A6 comprises the apparatus of Examples A1-A5, wherein the first plurality of interconnect layers comprises all interconnect layers located on a surface of the substrate and the first plurality of interconnect layers is located between the first substrate and the second integrated circuit die.

Example A7 comprises the apparatus of any one of Examples A1-A4, wherein individual of the first plurality of pads are directly attached to one of the first plurality of traces.

Example A8 comprises the apparatus of any one of Examples A1-A4, wherein the first plurality of traces belong to an interconnect layer that is a middle layer of the first plurality of interconnect layers.

Example A9 comprises the apparatus of any one of Examples A1-A4, wherein the first plurality of traces belong to a metal 4 (M4), metal 5 (M5), metal 6 (M6), metal 7 (M7), or metal 8 (M8) layer.

Example A10 comprises the apparatus of any one of Examples A1-A4, wherein the second integrated circuit die is positioned between a top-most interconnect layer of the first plurality of interconnect layers and the first substrate.

Example A11 comprises the apparatus of any one of Examples A1-A4, wherein the first plurality of traces belong to a first interconnect layer of the first plurality of interconnect layers and the second integrated circuit die extends through one or more second interconnect layers of the first plurality of interconnect layers.

Example A12 comprises the apparatus of any one of Examples A1-A11, wherein the second plurality of interconnect layers comprises at least four but no more than eight interconnect layers.

Example A13 comprises the apparatus of any one of Examples A1-A12, wherein the second integrated circuit die comprises a six-transistor static random-access memory bitcell (6T SRAM bitcell).

Example A14 comprises the apparatus of Example A13, wherein a first pad of the second plurality of pads is electrically conductively coupled to a gate of a transistor of the 6T SRAM bitcell and a second pad of the second plurality of pads is electrically conductively coupled to a source or a drain of the transistor of the 6T SRAM bitcell.

Example A15 comprises the apparatus of any one of Examples A1-A12, wherein the second integrated circuit die comprises an array of six-transistor static random-access memory bitcells.

Example A16 comprises the apparatus of any one of Examples A13-A15, wherein the second integrated circuit die further comprises one or more redundant rows or one or more redundant columns of 6T SRAM bitcells.

Example A17 comprises the apparatus of any one of Examples A1-A12, wherein the second integrated circuit die comprises a multiport SRAM bitcell.

Example A18 comprises the apparatus of any one of Examples A1-A12, wherein the second integrated circuit die comprises a content-Addressable memory (CAM) bitcell.

Example A19 comprises the apparatus of any one of Examples A1-A18, wherein the lateral area of the second integrated circuit die is less than 50% of the lateral area of the first integrated circuit die.

Example A20 comprises the apparatus of any one of Examples A1-A18, wherein the first integrated circuit die is manufactured by a first manufacturing process and the second integrated circuit die is manufactured by a second manufacturing process that is different than the first manufacturing process.

Example A21 comprises the apparatus of any one of Examples A1-A18, wherein the first integrated circuit die further comprises a first transistor located on the first substrate and the second integrated circuit die comprises a second transistor located on the second substrate, the first transistor has a planar field-effect transistor (FET), FinFET, or gate-All-Around FET (GAAFET) transistor type, the second transistor has a planar FET, FinFET or GAAFET transistor type, and the transistor type of the first transistor is different than the transistor type of the second transistor.

Example A22 comprises the apparatus of any one of Examples A1-A21, wherein the second plurality of pads of the second integrated circuit die are located on a first surface of the second integrated circuit die, the second integrated circuit die further comprising a third plurality of pads on a second surface of the second integrated circuit die that is opposite to the first surface of the second integrated circuit die, the apparatus further comprising a third integrated circuit die stacked on top of the second integrated circuit die, the third integrated circuit die comprising a third plurality of interconnect layers and a fourth plurality of pads electrically conductively coupled to the third plurality of interconnect layers, wherein individual pads of the third plurality of pads are bonded to a pad of the fourth plurality of pads.

Example A23 comprises the apparatus of Example A22, wherein the second integrated circuit die comprises a through-silicon via that extends from a pad of the third plurality of pads to a pad of the second plurality of pads.

Example A24 comprises the apparatus of Example A22, wherein: the first plurality of pads belong to a first interconnect layer of the first plurality of interconnect layers; and the second integrated circuit die and the third integrated circuit die are between the first substrate and a second interconnect layer of the first plurality of interconnect layers, the apparatus further comprising a via extending from a trace of the second interconnect layer to a trace of the first interconnect layer, the via extending through a trace of the second plurality of interconnect layers in the second integrated circuit die and a trace of the third plurality of interconnect layers in the third integrated circuit die to a trace of the first plurality of interconnect layers.

Example A25 is a device comprising: a first integrated circuit die comprising: a first substrate; a transistor located on the first substrate; a first plurality of interconnect layers located on the first substrate; and a first plurality of pads electrically conductively coupled to a first plurality of traces of the first plurality of interconnect layers; and a plurality of second integrated circuit dies, individual of the plurality of second integrated circuit dies comprising: a second substrate; a second transistor located on the first substrate; a second plurality of interconnect layers located on the second substrate; and a second plurality of pads electrically conductively coupled to a second plurality of traces of the second plurality of interconnect layers, wherein individual pads of the second plurality of pads are attached to a pad of the first plurality of pads, and a pitch of the second plurality of pads is less than about 500 nanometers; wherein the plurality of second integrated circuit dies are arranged laterally over the first integrated circuit die.

Example A26 comprises the device of Example A25, wherein individual of the first plurality of pads and individual of the second plurality of pads comprise a metal.

Example A27 comprises the device of Example A25, further comprising a printed circuit board, wherein the first integrated circuit die and the plurality of second integrated circuit dies are part of an integrated circuit component that is attached to the printed circuit board.

Example A28 comprises the device of Example A25, wherein the first plurality of interconnect layers is a frontside metallization stack.

Example A29 comprises the device of Example A25, wherein the first plurality of interconnect layers is a backside metallization stack.

Example A30 comprises the device of any one of Examples A25-A29, wherein: the first plurality of traces belong to a first interconnect layer of the first plurality of interconnect layers; and the first plurality of pads electrically conductively coupled to the first plurality of traces by a plurality of vias that extend through one or more second interconnect layers of the first plurality of interconnect layers, individual of the plurality of vias extending from one of the first plurality of pads to one of the first plurality of traces.

Example A31 comprises the device of Examples A25-A29, wherein the first plurality of interconnect layers is between the first substrate and the plurality of second integrated circuit dies.

Example A32 comprises the device of any one of Examples A25-A29, wherein individual of the first plurality of pads are directly attached to one of the first plurality of traces.

Example A33 comprises the device of any one of Examples A25-A29, wherein the first plurality of traces belong to an interconnect layer that is a middle layer of the first plurality of interconnect layers.

Example A34 comprises the device of Example A25, wherein the plurality of second integrated circuit dies is positioned between a top-most interconnect layer of the first plurality of interconnect layers and the first substrate.

Example A35 comprises the device of any one of Examples A25-A34, wherein the first plurality of traces belong to a first interconnect layer of the first plurality of interconnect layers and the plurality of second integrated circuit dies extends through one or more second interconnect layers of the first plurality of interconnect layers.

Example A36 comprises the device of any one of Examples A25-A35, wherein the second plurality of interconnect layers of individual integrated circuit dies of the plurality of second integrated circuit dies comprises at least four but no more than eight interconnect layers.

Example A37 comprises the device of any one of Examples A25-A36, wherein individual of the plurality of second integrated circuit dies comprises a six-transistor static random-access memory bitcell (6T SRAM bitcell).

Example A38 comprises the device of Example A37, wherein, for individual of the plurality of second integrated circuit dies, a first pad of the second plurality of pads is electrically conductively coupled to a gate of a transistor of the 6T SRAM bitcell and a second pad of the second plurality of pads is electrically conductively coupled to a source or a drain of the transistor of the 6T SRAM bitcell.

Example A39 comprises the device of any one of Examples A25-A36, wherein individual of the plurality of second integrated circuit dies comprises an array of 6T SRAM bitcells.

Example A40 comprises the device of any one of Examples A25-A39, wherein the first integrated circuit die is manufactured by a first manufacturing process and one of the plurality of second integrated circuit dies is manufactured by a second manufacturing process that is different than the first manufacturing process.

Example A41 comprises the device of any one of Examples A25-A39, wherein the first integrated circuit die is manufactured by a first manufacturing process, a first one of the plurality of second integrated circuit dies is manufactured by a second manufacturing process that is different than the first manufacturing process, and a second one of the plurality of second integrated circuit dies is manufactured by a third manufacturing process that is different than the first manufacturing process and the second manufacturing process.

Example A42 comprises the device of any one of Examples A25-A39, wherein a first one of the plurality of second integrated circuit dies comprises a plurality of 6T SRAM bitcells and a second one of the plurality of second integrated circuit dies comprises a plurality of dynamic random-access memory (DRAM) bitcell capacitors.

Example A43 comprises the device of any one of Examples A25-A39, wherein a first one of the plurality of second integrated circuit dies comprises a plurality of 6T SRAM bitcells and a second one of the plurality of second integrated circuit dies comprises a plurality of dynamic random-access memory (DRAM) bitcells.

Example A44 is a system comprising: an integrated circuit component comprising: a first integrated circuit die comprising a first substrate comprising silicon, a frontside metallization stack located on the first substrate, and a backside metallization stack located on the first substrate; a second integrated circuit die comprising a second substrate comprising silicon, a first metallization stack located on the second substrate, and a first plurality of pads electrically conductively coupled to a first plurality of traces of the frontside metallization stack; and a third integrated circuit die comprising a third substrate comprising silicon, a third metallization stack located on the third substrate, and a second plurality of pads electrically conductively coupled to a second plurality of traces of the backside metallization stack, wherein a pitch of the first plurality of pads and a pitch of the second plurality of pads is less than about 500 nanometers, and a lateral area of the second integrated circuit die and a lateral area of the third integrated circuit die are less than a lateral area of the first integrated circuit die; and a printed circuit board, wherein the integrated circuit component is attached to the printed circuit board.

Example A45 comprises the system of Example A44, wherein the integrated circuit component is a first integrated circuit component, the system further comprising a second integrated circuit component attached to the printed circuit board.

Example A46 comprises the system of Example A44, wherein individual of the first plurality of pads and individual of the second plurality of pads comprise a metal.

Example A47 comprises the system of any one of Examples A44-A46, wherein the first plurality of pads are electrically conductively coupled to the frontside metallization stack by a first plurality of vias that extend through one of more interconnect layers of the frontside metallization stack and the second plurality of pads are electrically conductively coupled to the backside metallization stack by a second plurality of vias that extend through one or more interconnect layers of the backside metallization stack.

Example A48 comprises the system of any one of Examples A44-A46, wherein the frontside metallization stack comprises all interconnect layers located on a first surface of the first substrate, the frontside metallization stack is between the second integrated circuit die and the first substrate, the backside metallization stack comprises all interconnect layers located on a second surface of the first substrate, and the backside metallization stack is between the third integrated circuit die and the first substrate.

Example A49 comprises the system of Example A44, wherein the second integrated circuit die is positioned between a top-most interconnect layer of the frontside metallization stack and the first substrate.

Example A50 comprises the system of Example A44, wherein the third integrated circuit die is positioned between a top-most interconnect layer of the backside metallization stack and the first substrate.

Example A51 comprises the system of any one of Examples A44-A50, wherein the first metallization stack comprises at least four but no more than eight interconnect layers.

Example A52 comprises the system of any one of Examples A44-A51, wherein the second integrated circuit die comprises a six-transistor static random-access memory bitcell (6T SRAM bitcell).

Example A53 comprises the system of Example A52, wherein a first pad of the first plurality of pads is electrically conductively coupled to a gate of a transistor of the 6T SRAM bitcell and a second pad of the first plurality of pads is electrically conductively coupled to a source or a drain of the transistor of the 6T SRAM bitcell.

Example A54 comprises the system of any one of Examples A45-A53, wherein the first integrated circuit die is manufactured by a first manufacturing process and the second integrated circuit die is manufactured by a second manufacturing process that is different than the first manufacturing process.

Example A55 comprises the system of any one of Examples A45-A53, wherein the first integrated circuit die is manufactured by a first manufacturing process, the second integrated circuit die is manufactured by a second manufacturing process that is different than the first manufacturing process, and the third integrated circuit die is manufactured by a third manufacturing process that is different than the first manufacturing process and the second manufacturing process.

Example A56 comprises the system of Example A44, wherein the first integrated circuit die comprises a plurality of 6T SRAM bitcells and the second integrated circuit die comprises a plurality of dynamic random-access memory (DRAM) bitcell capacitors.

Example A57 comprises the system of Example A44, wherein the first integrated circuit die comprises a plurality of 6T SRAM bitcells and the second integrated circuit die comprises a plurality of dynamic random-access memory (DRAM) bitcells.

Example A58 is a method comprising: forming an integrated circuit structure comprising a first substrate, a first transistor located on the first substrate, and a first plurality of interconnect layers located on the first substrate; forming a first plurality of pads on a top-most interconnect layer of the first plurality of interconnect layers, the first plurality of pads electrically conductively coupled to a plurality of traces of the top-most interconnect layer; and attaching an integrated circuit die to the integrated circuit structure, wherein the integrated circuit die comprises a second substrate, a second transistor located on the second substrate, a second plurality of interconnect layers, and a second plurality of pads electrically conductively coupled to a top-most interconnect layer of the second plurality of interconnect layers; wherein attaching the integrated circuit die to the integrated circuit structure comprises bonding the first plurality of pads to the second plurality of pads, a pitch of the first plurality of pads is less than about 500 nanometers, and a lateral area of the integrated circuit die is less than a lateral area of the first substrate.

Example A59 comprises the method of Example A58, wherein the first plurality of interconnect layers is a frontside metallization stack.

Example A60 comprises the method of Example A58, wherein the first plurality of interconnect layers is a backside metallization stack.

Example A61 comprises the method of Example A58, further comprising forming the integrated circuit die.

Example A62 comprises the method of Example A58, further comprising forming a third plurality of interconnect layers over the first plurality of interconnect layers and the integrated circuit die.

Example A63 comprises the method of any one of Examples A58-A62, wherein the integrated circuit die comprises a six-transistor static random-access memory bitcell (6T SRAM bitcell).

Example A64 comprises the method of Example A63, wherein a first pad of the second plurality of pads is electrically conductively coupled to a gate of a pass gate transistor of the 6T SRAM bitcell and a second pad of the second plurality of pads is electrically conductively coupled to a source or a drain of the pass gate transistor of the 6T SRAM bitcell.

Example A65 comprises the method of any one of Examples A58-A64, wherein a first manufacturing process used to form the integrated circuit structure is different than a second manufacturing process used to form the integrated circuit die.

Example A66 comprises the method of any one of Examples A58-A63, wherein the integrated circuit die is attached to the integrated circuit structure via hybrid bonding.

Example A67 comprises the method of Example A58, wherein the integrated circuit die is a first integrated circuit die, the plurality of traces of an interconnect layer of the first plurality of interconnect layers is a first plurality of traces, the method further comprising: forming a third plurality of pads electrically conductively coupled to a second plurality of metal traces of a top-most layer of the first plurality of interconnect layers; and attaching a second integrated circuit die comprising a third plurality of interconnect layers and a fourth plurality of pads attached to a top-most layer of the third plurality of interconnect layers, wherein individual pads of the fourth plurality of pads are bonded to a pad of the third plurality of pads, and a pitch of the third plurality of pads being less than about 500 nanometers.

Example B1 is an apparatus, comprising: a first integrated circuit die comprising: a substrate comprising silicon; a first plurality of interconnect layers located on the substrate; and a first plurality of pads electrically conductively coupled to a first plurality of traces of the first plurality of interconnect layers; and a second integrated circuit die comprising: a capacitor comprising a first electrode, a second electrode, and a layer comprising a dielectric material positioned between the first electrode and the second electrode, wherein the capacitor is substantially vertically oriented with respect to the substrate; a second plurality of interconnect layers; and a second plurality of pads electrically conductively coupled to a second plurality of traces of the second plurality of interconnect layers, wherein individual pads of the first plurality of pads are attached to a pad of the second plurality of pads, a pitch of the first plurality of pads is less than about 500 nanometers, a lateral area of the second integrated circuit die is less than a lateral area of the first integrated circuit die, and individual of the first plurality of pads and individual of the second plurality of pads comprise a metal.

Example B2 comprises the apparatus of Example B1, wherein the second integrated circuit die does not comprise any transistors.

Example B3 comprises the apparatus of Example B1, wherein the substrate is a first substrate, the second integrated circuit die further comprises a second substrate and a transistor located on the second substrate, and a source or drain of the transistor is electrically conductively coupled to the first electrode of the capacitor.

Example B4 comprises the apparatus of Example B1, wherein the first integrated circuit die further comprises a transistor located on the substrate, and a source or drain of the transistor is electrically conductively coupled to the first electrode of the capacitor.

Example B5 comprises the apparatus of Example B1, wherein the first integrated circuit die further comprises a transistor located on the substrate and the first plurality of interconnect layers is a frontside metallization stack.

Example B6 comprises the apparatus of Example B1, wherein the first integrated circuit die further comprises a transistor located on the substrate and the first plurality of interconnect layers is a backside metallization stack.

Example B7 comprises the apparatus of any one of Examples B1-B6, where the substrate is a first substrate, the second integrated circuit die further comprising: a second substrate comprising silicon; and a third plurality of interconnect layers, wherein the substrate is positioned between the second plurality of interconnect layers and the third plurality of interconnect layers.

Example B8 comprises the apparatus of any one of Examples B1-B7, wherein: the first plurality of traces belong to a first interconnect layer of the first plurality of interconnect layers; and the first plurality of pads are electrically conductively coupled to the first plurality of traces by a plurality of vias that extend through one or more second interconnect layers of the first plurality of interconnect layers, individual of the plurality of vias extending from one of the first plurality of pads to one of the first plurality of traces.

Example B9 comprises the apparatus of Examples B1-B8, wherein the first plurality of interconnect layers comprises all interconnect layers located on a surface of the substrate and the first plurality of interconnect layers is between the substrate and the second integrated circuit die.

Example B10 comprises the apparatus of any one of Examples B1-B7, wherein individual of the first plurality of pads are directly attached to one of the first plurality of traces.

Example B11 comprises the apparatus of any one of Examples B1-B7, wherein the first plurality of traces belong to an interconnect layer that is a middle layer of the first plurality of interconnect layers.

Example B12 comprises the apparatus of any one of Examples B1-B7, wherein the first plurality of traces belong to a metal 4 (M4), metal 5 (M5), metal 6 (M6), metal 7 (M7), or metal 8 (M8) layer.

Example B13 comprises the apparatus of any one of Examples B1-B7, wherein the second integrated circuit die is positioned between a top-most interconnect layer of the first plurality of interconnect layers and the substrate.

Example B14 comprises the apparatus of any one of Examples B1-B7, wherein the first plurality of traces belong to a first interconnect layer of the first plurality of interconnect layers and the second integrated circuit die extends through one or more second interconnect layers of the first plurality of interconnect layers.

Example B15 comprises the apparatus of any one of Examples B1-B14, wherein the second plurality of interconnect layers comprises eight or fewer interconnect layers.

Example B16 comprises the apparatus of any one of Examples B1-B15, wherein the second integrated circuit die comprises a dynamic random-access memory bitcell (DRAM bitcell) that comprises the capacitor.

Example B17 comprises the apparatus of Example B16, wherein a first pad of the second plurality of pads is electrically conductively coupled to a gate of a transistor of the DRAM bitcell and a second pad of the second plurality of pads is electrically conductively coupled to a source or a drain of the transistor of the DRAM bitcell.

Example B18 comprises the apparatus of any one of Examples B1-B15, wherein the second integrated circuit die comprises an array of dynamic random-access memory bitcells (DRAM bitcells).

Example B19 comprises the apparatus of any one of Examples B16-B18, wherein the second integrated circuit die further comprises one or more redundant rows or one or more redundant columns of DRAM bitcells.

Example B20 comprises the apparatus of any one of Examples B1-B19, wherein the lateral area of the second integrated circuit die is less than 50% of the lateral area of the first integrated circuit die.

Example B21 comprises the apparatus of any one of Examples B1-B19, wherein the first integrated circuit die is manufactured by a first manufacturing process and the second integrated circuit die is manufactured by a second manufacturing process that is different than the first manufacturing process.

Example B22 comprises the apparatus of any one of Examples B1-B19, wherein the substrate is a first substrate, the first integrated circuit die further comprising a first transistor located on the first substrate and the second integrated circuit die comprises a second substrate and a second transistor located on the second substrate, the first transistor has a planar field-effect transistor (FET), FinFET, or gate-all-around FET (GAAFET) transistor type, the second transistor has a planar FET, FinFET or GAAFET transistor type, and the transistor type of the first transistor is different than the transistor type of the second transistor.

Example B23 comprises the apparatus of any one of Examples B1-B22, wherein the second plurality of pads of the second integrated circuit die are located on a first surface of the second integrated circuit die, the second integrated circuit die further comprising a third plurality of pads on a second surface of the second integrated circuit die that is opposite to the first surface of the second integrated circuit die, the apparatus further comprising a third integrated circuit die stacked on top of the second integrated circuit die, the third integrated circuit die comprising a third plurality of interconnect layers and a fourth plurality of pads electrically conductively coupled to the third plurality of interconnect layers, wherein individual pads of the third plurality of pads are bonded to a pad of the fourth plurality of pads.

Example B24 comprises the apparatus of Example B23, wherein the second integrated circuit die comprises a through-silicon via that extends from a pad of the third plurality of pads to a pad of the second plurality of pads.

Example B25 comprises the apparatus of Example B23, wherein: the first plurality of pads belong to a first interconnect layer of the first plurality of interconnect layers; and the second integrated circuit die and the third integrated circuit die are between the substrate and a second interconnect layer of the first plurality of interconnect layers, the apparatus further comprising a via extending from a trace of the second interconnect layer to a trace of the first interconnect layer, the via extending through a trace of the second plurality of interconnect layers in the second integrated circuit die and a trace of the third plurality of interconnect layers in the third integrated circuit die to a trace of the first plurality of interconnect layers.

Example B26 is a device comprising: a first integrated circuit die comprising: a substrate comprising silicon; a first plurality of interconnect layers located on the substrate; and a first plurality of pads electrically conductively coupled to a first plurality of traces of the first plurality of interconnect layers; and a plurality of second integrated circuit dies comprising: a capacitor comprising a first electrode, a second electrode, and a layer comprising a dielectric material positioned between the first electrode and the second electrode, wherein the capacitor is substantially vertically oriented with respect to the substrate; a second plurality of interconnect layers; and a second plurality of pads electrically conductively coupled to a second plurality of traces of the second plurality of interconnect layers, wherein individual pads of the second plurality of pads are attached to a pad of the first plurality of pads, and a pitch of the first plurality of pads is less than about 500 nanometers; wherein a lateral area of individual of the plurality of second integrated circuit dies is less than a lateral area of the first integrated circuit die, and the plurality of second integrated circuit dies are arranged laterally over the first integrated circuit die.

Example B27 comprises the device of Example B26, wherein individual of the plurality of second integrated circuit dies does not comprise any transistors.

Example B28 comprises the device of Example B26, wherein the substrate is a first substrate and wherein individual of the plurality of second integrated circuit dies comprise a second substrate comprising a transistor located on the second substrate, a source or drain of the transistor electrically conductively coupled to the first electrode of the capacitor.

Example B29 comprises the device of Example B26, wherein the first integrated circuit die further comprises a transistor located on the substrate, and a source or drain of the transistor is electrically conductively coupled to the first electrode of the capacitor.

Example B30 comprises the device of Example B26, further comprising a printed circuit board, wherein the first integrated circuit die and the plurality of second integrated circuit dies are part of an integrated circuit component that is attached to the printed circuit board.

Example B31 comprises the device of Example B26, wherein the first plurality of interconnect layers is a frontside metallization stack.

Example B32 comprises the device of Example B26, wherein the first plurality of interconnect layers is a backside metallization stack.

Example B33 comprises the device of any one of Examples B26-B32, wherein: the first plurality of traces belong to a first interconnect layer of the first plurality of interconnect layers; and the first plurality of pads electrically conductively coupled to the first plurality of traces by a plurality of vias that extend through one or more second interconnect layers of the first plurality of interconnect layers, individual of the plurality of vias extending from one of the first plurality of pads to one of the first plurality of traces.

Example B34 comprises the device of Examples B26-B32, wherein the first plurality of interconnect layers is between the substrate and the plurality of second integrated circuit dies.

Example B35 comprises the device of any one of Examples B26-B32, wherein individual of the first plurality of pads are directly attached to one of the first plurality of traces.

Example B36 comprises the device of any one of Examples B26-B32, wherein the first plurality of traces belong to an interconnect layer that is a middle layer of the first plurality of interconnect layers.

Example B37 comprises the device of Example B26, wherein the plurality of second integrated circuit dies is positioned between a top-most interconnect layer of the first plurality of interconnect layers and the substrate.

Example B38 comprises the device of any one of Examples B26-B37, wherein the first plurality of traces belong to a first interconnect layer of the first plurality of interconnect layers and the plurality of second integrated circuit dies extends through one or more second interconnect layers of the first plurality of interconnect layers.

Example B39 comprises the device of any one of Examples B26-B38, wherein the second plurality of interconnect layers of individual integrated circuit dies of the plurality of second integrated circuit dies comprises eight or fewer interconnect layers.

Example B40 comprises the device of any one of Examples B26-B39, wherein individual of the plurality of second integrated circuit dies comprises a dynamic random-access memory bitcell (DRAM bitcell) that comprises the capacitor.

Example B41 comprises the device of Example B40, wherein, for individual of the plurality of second integrated circuit dies, a first pad of the second plurality of pads is electrically conductively coupled to a gate of a transistor of the DRAM bitcell and a second pad of the second plurality of pads is electrically conductively coupled to a source or a drain of the transistor of the DRAM bitcell.

Example B42 comprises the device of any one of Examples B26-B39, wherein individual of the plurality of second integrated circuit dies comprises an array of dynamic random-access memory bitcells.

Example B43 comprises the device of any one of Examples B26-B42, wherein the first integrated circuit die is manufactured by a first manufacturing process and one of the plurality of second integrated circuit dies is manufactured by a second manufacturing process that is different than the first manufacturing process.

Example B44 comprises the device of any one of Examples B26-B42, wherein the first integrated circuit die is manufactured by a first manufacturing process, a first one of the plurality of second integrated circuit dies is manufactured by a second manufacturing process that is different than the first manufacturing process, and a second one of the plurality of second integrated circuit dies is manufactured by a third manufacturing process that is different than the first manufacturing process and the second manufacturing process.

Example B45 comprises the device of any one of Examples B26-B42, wherein a first one of the plurality of second integrated circuit dies comprises a plurality of 6T static random-access memory bitcells and a second one of the plurality of second integrated circuit dies comprises a plurality of dynamic random-access memory bitcell capacitors.

Example B46 comprises the device of any one of Examples B26-B42, wherein a first one of the plurality of second integrated circuit dies comprises a plurality of 6T static random-access memory bitcells and a second one of the plurality of second integrated circuit dies comprises a plurality of dynamic random-access memory bitcells.

Example B47 is a system comprising: an integrated circuit component comprising: a first integrated circuit die comprising a first substrate comprising silicon, a frontside metallization stack located on the first substrate, and a backside metallization stack located on the first substrate; a second integrated circuit die comprising a first capacitor, a second plurality of interconnect layers; and a first plurality of pads electrically conductively coupled to a second plurality of traces of the second plurality of interconnect layers; and a third integrated circuit die comprising a second capacitor, a second plurality of interconnect layers, and a second plurality of pads electrically conductively coupled to a second plurality of traces of the second plurality of interconnect layers, wherein individual pads of the first plurality of pads are attached to a pad of the second plurality of pads, a pitch of the first plurality of pads is less than about 500 nanometers, the first capacitor and the second capacitor are substantially vertically oriented with respect to the first substrate, a lateral area of the second integrated circuit die and a lateral area of the third integrated circuit die are less than a lateral area of the first integrated circuit die; and a printed circuit board, wherein the integrated circuit component is attached to the printed circuit board.

Example B48 comprises the system of Example B47, wherein the first capacitor comprises a first electrode, a second electrode, and a first layer comprising a dielectric material positioned between the first electrode and the second electrode, and the second capacitor comprises a third electrode, a fourth electrode, and a second layer comprising the dielectric material positioned between the third electrode and the fourth electrode.

Example B49 comprises the system of Example B47, wherein the integrated circuit component is a first integrated circuit component, the system further comprising a second integrated circuit component attached to the printed circuit board.

Example B50 comprises the system of Example B47, wherein individual of the first plurality of pads and individual of the second plurality of pads comprise a metal.

Example B51 comprises the system of any one of Examples B47-B50, wherein the first plurality of pads are electrically conductively coupled to the frontside metallization stack by a first plurality of vias that extend through one of more interconnect layers of the frontside metallization stack and the second plurality of pads are electrically conductively coupled to the backside metallization stack by a second plurality of vias that extend through one or more interconnect layers of the backside metallization stack.

Example B52 comprises the system of any one of Examples B47-B50, wherein the frontside metallization stack is between the second integrated circuit die and the first substrate and the backside metallization stack is between the third integrated circuit die and the first substrate.

Example B53 comprises the system of Example B47, wherein the second integrated circuit die is positioned between a top-most interconnect layer of the frontside metallization stack and the frontside metallization stack comprises all interconnect layers on a surface of the first substrate.

Example B54 comprises the system of Example B47, wherein the third integrated circuit die is positioned between a top-most interconnect layer of the backside metallization stack and the backside metallization stack comprises all of interconnect layers on a surface of the first substrate.

Example B55 comprises the system of any one of Examples B47-B50, wherein the frontside metallization stack comprises eight or fewer interconnect layers.

Example B56 comprises the system of any one of Examples B47-B51, wherein the second integrated circuit die comprises a dynamic random-access memory bitcell (DRAM bitcell) comprising the first capacitor.

Example B57 comprises the system of Example B56, wherein a first pad of the first plurality of pads is electrically conductively coupled to a gate of a transistor of the DRAM bitcell and a second pad of the first plurality of pads is electrically conductively coupled to a source or a drain of the transistor of the DRAM bitcell.

Example B58 comprises the system of any one of Examples B47-B57, wherein the first integrated circuit die is manufactured by a first manufacturing process and the second integrated circuit die is manufactured by a second manufacturing process that is different than the first manufacturing process.

Example B59 comprises the system of any one of Examples B47-B57, wherein the first integrated circuit die is manufactured by a first manufacturing process, the second integrated circuit die is manufactured by a second manufacturing process that is different than the first manufacturing process, and the third integrated circuit die is manufactured by a third manufacturing process that is different than the first manufacturing process and the second manufacturing process.

Example B60 comprises the system of any one of Examples B47-B59, wherein the first integrated circuit die comprises a plurality of 6T SRAM bitcells and the second integrated circuit die comprises a plurality of DRAM bitcell capacitors, the plurality of DRAM bitcell capacitors comprising the first capacitor.

Example B61 comprises the system of any one of Examples B47-B59, wherein the first integrated circuit die comprises a plurality of 6T SRAM bitcells and the second integrated circuit die comprises a plurality of DRAM bitcell that comprises the first capacitor.

Example B62 is a method comprising: forming an integrated circuit structure comprising a substrate, a first plurality of interconnect layers, the first plurality of interconnect layers located on a first substrate comprising a transistor located on the first substrate; forming a first plurality of pads on a top-most interconnect layer of the first plurality of interconnect layers, the first plurality of pads electrically conductively coupled to a plurality of traces of the top-most interconnect layer; and attaching an integrated circuit die to the integrated circuit structure, wherein the integrated circuit die comprises a capacitor, a second plurality of interconnect layers and a second plurality of pads electrically conductively coupled to a top-most interconnect layer of the second plurality of interconnect layers, attaching the integrated circuit die to the integrated circuit structure comprises bonding the first plurality of pads to the second plurality of pads, a pitch of the first plurality of pads is less than about 500 nanometers, a lateral area of the integrated circuit die is less than a lateral area of the integrated circuit die, and the capacitor is vertically oriented relative to the substrate.

Example B63 comprises the method of Example B62, wherein the capacitor comprises a first electrode, a second electrode, and a first layer comprising a dielectric material positioned between the first electrode and the second electrode, wherein the capacitor is substantially vertically oriented with respect to the substrate.

Example B64 comprises the method of Example B62, wherein the first plurality of interconnect layers is a frontside metallization stack.

Example B65 comprises the method of Example B62, wherein the first plurality of interconnect layers is a backside metallization stack.

Example B66 comprises the method of Example B63, further comprising forming the integrated circuit die.

Example B67 comprises the method of Example B63, further comprising forming a third plurality of interconnect layers over the first plurality of interconnect layers and the integrated circuit die.

Example B68 comprises the method of any one of Examples B62-B67, wherein the integrated circuit die comprises a dynamic random-access memory that comprises the capacitor.

Example B69 comprises the method of Example B68, wherein a first pad of the second plurality of pads is electrically conductively coupled to a gate of an access transistor of a dynamic random-access memory bitcell (DRAM bitcell) and a second pad of the second plurality of pads is electrically conductively coupled to a source or a drain of the access transistor of the DRAM bitcell.

Example B70 comprises the method of any one of Examples B62-B69, wherein a first manufacturing process used to form the integrated circuit structure is different than a second manufacturing process used to form the integrated circuit die.

Example B71 comprises the method of any one of Examples B62-B70, wherein the integrated circuit die is attached to the integrated circuit structure via hybrid bonding.

Example B72 comprises the method of any one of Examples B62-B71, wherein the capacitor is a first capacitor, the integrated circuit die is a first integrated circuit die, the plurality of traces of an interconnect layer of the first plurality of interconnect layers is a first plurality of traces, the method further comprising: forming a third plurality of pads electrically conductively coupled to a second plurality of metal traces of a top-most layer of the first plurality of interconnect layers; and attaching a second integrated circuit die comprising a second capacitor that is vertically oriented relative to the substrate, a third plurality of interconnect layers and a fourth plurality of pads attached to a top-most layer of the third plurality of interconnect layers, wherein individual pads of the fourth plurality of pads are bonded to a pad of the third plurality of pads, and a pitch of the third plurality of pads being less than about 500 nanometers.

Example C1 is an apparatus comprising: a first integrated circuit die comprising: a first substrate comprising silicon; a first logic standard cell located on the first substrate, the first logic standard cell having a first standard cell height; a first plurality of interconnect layers located on the first substrate; and a first plurality of pads electrically conductively coupled to a first plurality of traces of the first plurality of interconnect layers; and a second integrated circuit die comprising: a second substrate comprising silicon; a second logic standard cell located on the second substrate, the second logic standard cell having a second standard cell height that is less than the first standard cell height; a second plurality of interconnect layers located on the second substrate; and a second plurality of pads electrically conductively coupled to a second plurality of traces of the second plurality of interconnect layers, wherein individual pads of the first plurality of pads are attached to a pad of the second plurality of pads, and a pitch of the first plurality of pads is less than about 500 nanometers.

Example C2 comprises the apparatus of Example C1, wherein the pitch of the first plurality of pads is in a range of about 40-100 nanometers.

Example C3 comprises the apparatus of Example C1, wherein individual of the first plurality of pads and individual of the second plurality of pads comprise a metal.

Example C4 comprises the apparatus of any one of Examples C1-C3, wherein: the first logic standard cell comprises a first transistor; the second logic standard cell comprises a second transistor; and a gate, source or drain of the first transistor is electrically conductively coupled to a gate, source, or drain of the second transistor.

Example C5 comprises the apparatus of any one of Examples C1-C4, wherein the first logic standard cell comprises a first fin field-effect transistor (FinFET) and can accommodate a first maximum number of FinFET fins within the first standard cell height, the second logic standard cell comprises a second FinFET and can accommodate a second maximum number of FinFET fins within the second standard cell height, and the first maximum number of FinFET fins is different than the second maximum number of FinFET fins.

Example C6 comprises the apparatus of any one of Examples C1-C4, wherein the first logic standard cell is belongs to a first plurality of first logic standard cells arranged in a first row located on the first substrate, the second logic standard cell belongs to a second plurality of second logic standard cells arranged in a second row located on the second substrate, the first logic standard cell comprises a first fin field-effect transistor (FinFET), the second logic standard cell comprises a second FinFET, the first row comprising a first maximum number of FinFET fins arranged along the first standard cell height, the second row comprising a second maximum number of FinFET fins arranged along the second standard cell height, and the first maximum number of FinFET fins is different than the second maximum number of FinFET fins.

Example C7 comprises the apparatus of Example C6, wherein the first logic standard cell comprises the first maximum number of FinFET fins, the second logic standard cell comprises the second maximum number of FinFET fins, and a first spacing between adjacent n-type fins in the first logic standard cell is different than a second spacing between adjacent n-type FinFET fins in the second logic standard cell.

Example C8 comprises the apparatus of Example C6, wherein the first logic standard cell comprises the first maximum number of FinFET fins, the second logic standard cell comprises the second maximum number of FinFET fins, and a first spacing between an n-type fin that is nearest a p-type fin in the first logic standard cell is different than a second spacing between an n-type FinFET fin that is nearest a p-type fin in the second logic standard cell.

Example C9 comprises the apparatus of any one of Examples C1-C4, wherein the first logic standard cell comprises an n-type gate-all-around transistor (GAAFET) having a first number of channel regions, the second logic standard cell comprises an n-type GAAFET having a second number of channel regions, and the first number of channel regions is different from the second number of channel regions.

Example C10 comprises the apparatus of any one of Examples C1-C4, wherein the first logic standard cell comprises a first spacing between a channel region of an n-type GAAFET and a channel region of a p-type GAAFET, the second logic standard cell comprises a second spacing between a channel region of an n-type GAAFET and a channel region of a p-type GAAFET, and the first spacing is different than the second spacing.

Example C11 comprises the apparatus of any one of Examples C1-C10, wherein a lateral area of the second integrated circuit die is less than a lateral area of the first integrated circuit die.

Example C12 comprises the apparatus of Example C11, wherein the lateral area of the second integrated circuit die is less than 50% of the lateral area of the first integrated circuit die.

Example C13 comprises the apparatus of any one of Examples C1-C12, wherein the first plurality of interconnect layers is a frontside metallization stack.

Example C14 comprises the apparatus of any one of Examples C1-C12, wherein the first plurality of interconnect layers is a backside metallization stack.

Example C15 comprises the apparatus of any one of Examples C1-C14, wherein: the first plurality of traces belong to a first interconnect layer of the first plurality of interconnect layers; and the first plurality of pads are electrically conductively coupled to the first plurality of traces by a plurality of vias that extend through one or more second interconnect layers of the first plurality of interconnect layers, individual of the plurality of vias extending from one of the first plurality of pads to one of the first plurality of traces.

Example C16 comprises the apparatus of Examples C1-C14, wherein the first plurality of interconnect layers comprises all interconnect layers located on a first surface of the first substrate and the first plurality of interconnect layers is between the first substrate and the second integrated circuit die.

Example C17 comprises the apparatus of any one of Examples C1-VC14, wherein the first plurality of traces belong to an interconnect layer that is a middle layer of the first plurality of interconnect layers.

Example C18 comprises the apparatus of any one of Examples C1-C14, wherein the first plurality of traces belong to a metal 4 (M4), metal 5 (M5), metal 6 (M6), metal 7 (M7), or metal 8 (M8) layer.

Example C19 comprises the apparatus of any one of Examples C1-C14, wherein the second integrated circuit die is positioned between a top-most interconnect layer of the first plurality of interconnect layers and the first substrate.

Example C20 comprises the apparatus of any one of Examples C1-C14, wherein the first plurality of traces belong to a first interconnect layer of the first plurality of interconnect layers and the second integrated circuit die extends through one or more second interconnect layers of the first plurality of interconnect layers.

Example C21 comprises the apparatus of any one of Examples C1-C20, wherein the second plurality of interconnect layers comprises eight or fewer interconnect layers.

Example C22 comprises the apparatus of any one of Examples C1-C21, wherein the first integrated circuit die is manufactured by a first manufacturing process and the second integrated circuit die is manufactured by a second manufacturing process that is different than the first manufacturing process.

Example C23 comprises the apparatus of any one of Examples C1-C8, wherein: the first logic standard cell comprises a first transistor; the second logic standard cell comprises a second transistor; the first transistor is a planar field-effect transistor (FET), fin FET, or gate-all-around FET (GAAFET); the second transistor is a planar FET, fin FET or GAAFET transistor type; and the first transistor has a different transistor type than the second transistor.

Example C24 comprises the apparatus of any one of Examples C1-C23, wherein the second plurality of pads of the second integrated circuit die are located on a first surface of the second integrated circuit die, the second integrated circuit die further comprising a third plurality of pads on a second surface of the second integrated circuit die that is opposite to the first surface of the second integrated circuit die, the apparatus further comprising a third integrated circuit die stacked on top of the second integrated circuit die, the third integrated circuit die comprising a third plurality of interconnect layers and a fourth plurality of pads electrically conductively coupled to the third plurality of interconnect layers, wherein individual pads of the third plurality of pads are bonded to a pad of the fourth plurality of pads.

Example C25 comprises the apparatus of any one of Examples C1-C23, the apparatus further comprising a third integrated circuit die comprising: a third substrate comprising silicon; a third logic standard cell located on the third substrate, the third logic standard cell having a third standard cell height that is different from the first standard cell height and the second standard cell height; a third plurality of interconnect layers located on the third substrate; and a third plurality of pads electrically conductively coupled to a third plurality of traces of the third plurality of interconnect layers, wherein individual pads of the first plurality of pads are attached to a pad of the third plurality of pads, and a pitch of the first plurality of pads is less than about 500 nanometers.

Example C26 is a device comprising: a first integrated circuit die comprising: a first substrate comprising silicon; a first logic standard cell located on the first substrate, the first logic standard cell having a first standard cell height; a first plurality of interconnect layers located on the first substrate; and a first plurality of pads electrically conductively coupled to a first plurality of traces of the first plurality of interconnect layers; and a second integrated circuit die comprising: a second substrate comprising silicon; a second logic standard cell located on the second substrate, the second logic standard cell having a second standard cell height; a second plurality of interconnect layers located on the second substrate; and a second plurality of pads electrically conductively coupled to a second plurality of traces of the second plurality of interconnect layers, wherein individual pads of the second plurality of pads are attached to a pad of the first plurality of pads, a pitch of the first plurality of pads is less than about 500 nanometers; wherein the first logic standard cell comprises a first fin field-effect transistor (FinFET) and can accommodate a first maximum number of FinFET fins within the first standard cell height, the second logic standard cell comprises a second FinFET and can accommodate a second maximum number of FinFET fins within the second standard cell height, and the first maximum number of FinFET fins is different than the second maximum number of FinFET fins, and a pitch of the first plurality of pads is less than about 500 nanometers.

Example C27 comprises the device of Example C26, wherein the first logic standard cell has a first standard cell height, the second logic standard cell has a second standard cell height, and the first standard cell height is different than the second standard cell height.

Example C28 comprises the device of any one of Examples C26 or C27, wherein the first logic standard cell comprises a first transistor, the second logic standard cell comprises a second transistor, and a gate, source or drain of the first transistor is electrically conductively coupled to a gate, source, or drain of the second transistor.

Example C29 comprises the device of any one of Examples C26-C28, wherein the first logic standard cell is belongs to a first plurality of first logic standard cells arranged in a first row located on the first substrate, the second logic standard cell belongs to a second plurality of second logic standard cells arranged in a second row located on the second substrate, first row comprising a first maximum number of FinFET fins arranged along the first standard cell height, the second row comprising a second maximum number of FinFET fins arranged along the second standard cell height, and the first maximum number of FinFET fins is different than the second maximum number of FinFET fins.

Example C30 comprises the device of Example C29, wherein the first logic standard cell comprises the first maximum number of FinFET fins and the second logic standard cell comprises the second maximum number of FinFET fins, and a first spacing between adjacent n-type fins in the first logic standard cell is different than a second spacing between adjacent n-type FinFET fins in the second logic standard cell.

Example C31 comprises the device of Example C29, wherein the first logic standard cell comprises the first maximum number of FinFET fins and the second logic standard cell comprises the second maximum number of FinFET fins, and a first spacing between an n-type fin that is nearest a p-type fin in the first logic standard cell is different than a second spacing between an n-type FinFET fin that is a nearest a p-type fin in the second logic standard cell.

Example C32 comprises the device of any one of Examples C26-C31, wherein a lateral area of the second integrated circuit die is less than a lateral area of the first integrated circuit die.

Example C33 comprises the device of any one of Examples C26-C32, wherein the first plurality of interconnect layers is a frontside metallization stack.

Example C34 comprises the device of any one of Examples C26-C32, wherein the first plurality of interconnect layers is a backside metallization stack.

Example C35 comprises the device of any one of Examples C26-C34, wherein: the first plurality of traces belong to a first interconnect layer of the first plurality of interconnect layers; and the first plurality of pads are electrically conductively coupled to the first plurality of traces by a plurality of vias that extend through one or more second interconnect layers of the first plurality of interconnect layers, individual of the plurality of vias extending from one of the first plurality of pads to one of the first plurality of traces.

Example C36 comprises the device of any one of Examples C26-C34, wherein the first plurality of traces belong to an interconnect layer that is a middle layer of the first plurality of interconnect layers.

Example C37 comprises the device of any one of Examples C26-C34, wherein the first plurality of traces belong to a metal 4 (M4), metal 5 (M5), metal 6 (M6), metal 7 (M7), or metal 8 (M8) layer.

Example C38 comprises the device of any one of Examples C26-C34, wherein the second integrated circuit die is positioned between a top-most interconnect layer of the first plurality of interconnect layers and the first substrate.

Example C39 comprises the device of any one of Examples C26-C34, wherein the first plurality of traces belong to a first interconnect layer of the first plurality of interconnect layers and the second integrated circuit die extends through one or more second interconnect layers of the first plurality of interconnect layers.

Example C40 comprises the device of any one of Examples C26-C39, wherein the second plurality of interconnect layers comprises eight or fewer interconnect layers.

Example C41 comprises the device of any one of Examples C26-C40, wherein the first integrated circuit die is manufactured by a first manufacturing process and the second integrated circuit die is manufactured by a second manufacturing process that is different than the first manufacturing process.

Example C42 comprises the device of any one of Examples C26-C41, wherein the second plurality of pads of the second integrated circuit die are located on a first surface of the second integrated circuit die, the second integrated circuit die further comprising a third plurality of pads on a second surface of the second integrated circuit die that is opposite to the first surface of the second integrated circuit die, the device further comprising a third integrated circuit die stacked on top of the second integrated circuit die, the third integrated circuit die comprising a third plurality of interconnect layers and a fourth plurality of pads electrically conductively coupled to the third plurality of interconnect layers, wherein individual pads of the third plurality of pads are bonded to a pad of the fourth plurality of pads.

Example C43 comprises the device of any one of Examples C26-C41, the device further comprising a third integrated circuit die comprising: a third substrate comprising silicon; a third logic standard cell located on the third substrate, wherein the third logic standard cell has a third standard cell height, comprises a third fin field-effect transistor (FinFET) and can accommodate a third maximum number of FinFET fins within the first standard cell height that is different than the first maximum number of FinFET fins and the second maximum number of FinFET fins; a third plurality of interconnect layers located on the third substrate; and a third plurality of pads electrically conductively coupled to a third plurality of traces of the third plurality of interconnect layers, wherein individual pads of the first plurality of pads are attached to a pad of the third plurality of pads, and a pitch of the first plurality of pads is less than about 500 nanometers.

Example C44 comprises the device of Example C43, wherein the third logic standard cell comprises a gate-all-around field-effect transistor.

Example C45 is a system comprising: an integrated circuit component comprising: a first integrated circuit die comprising: a first substrate comprising silicon; a first logic standard cell located on the first substrate; a first plurality of interconnect layers located on the first substrate; and a first plurality of pads electrically conductively coupled to a first plurality of traces of the first plurality of interconnect layers; and a second integrated circuit die comprising: a second substrate comprising silicon; a second logic standard cell located on the second substrate; a second plurality of interconnect layers located on the second substrate; and a second plurality of pads electrically conductively coupled to a second plurality of traces of the second plurality of interconnect layers, wherein individual pads of the second plurality of pads are attached to a pad of the first plurality of pads, the first logic standard cell comprises an n-type gate-all-around transistor (GAAFET) having a first number of channel regions, the second logic standard cell comprises an n-type GAAFET having a second number of channel regions, the first number of channel regions is different from the second number of channel regions, and a pitch of the first plurality of pads is less than about 500 nanometers; and a printed circuit board, wherein the integrated circuit component is attached to the printed circuit board.

Example C46 comprises the system of Example C45, wherein the first logic standard cell has a first standard cell height, the second logic standard cell has a second standard cell height, and the first standard cell height is different than the second standard cell height.

Example C47 comprises the system of Example C45, wherein individual of the first plurality of pads and individual of the second plurality of pads comprise a metal.

Example C48 comprises the system of any one of Examples C45-C47, wherein: the first logic standard cell comprises a first transistor; the second logic standard cell comprises a second transistor; and a gate, source or drain of the first transistor is electrically conductively coupled to a gate, source, or drain of the second transistor.

Example C49 comprises the system of any one of Examples C45-C48, wherein the first plurality of interconnect layers is a frontside metallization stack.

Example C50 comprises the system of any one of Examples C45-C48, wherein the first plurality of interconnect layers is a backside metallization stack.

Example C51 comprises the system of any one of Examples C45-C50, wherein: the first plurality of traces belong to a first interconnect layer of the first plurality of interconnect layers; and the first plurality of pads are electrically conductively coupled to the first plurality of traces by a plurality of vias that extend through one or more second interconnect layers of the first plurality of interconnect layers, individual of the plurality of vias extending from one of the first plurality of pads to one of the first plurality of traces.

Example C52 comprises the system of any one of Examples C45-C50, wherein the first plurality of traces belong to an interconnect layer that is a middle layer of the first plurality of interconnect layers.

Example C53 comprises the system of any one of Examples C45-C50, wherein the first plurality of traces belong to a metal 4 (M4), metal 5 (M5), metal 6 (M6), metal 7 (M7), or metal 8 (M8) layer.

Example C54 comprises the system of any one of Examples C45-C50, wherein the second integrated circuit die is positioned between a top-most interconnect layer of the first plurality of interconnect layers and the first substrate.

Example C55 comprises the system of any one of Examples C45-C50, wherein the first plurality of traces belong to a first interconnect layer of the first plurality of interconnect layers and the second integrated circuit die extends through one or more second interconnect layers of the first plurality of interconnect layers.

Example C56 comprises the system of any one of Examples C45-C54, wherein the second plurality of interconnect layers comprises eight or fewer interconnect layers.

Example C57 comprises the system of any one of Examples C45-C55, wherein the first integrated circuit die is manufactured by a first manufacturing process and the second integrated circuit die is manufactured by a second manufacturing process that is different than the first manufacturing process.

Example C58 comprises the system of any one of Examples C45-C57, wherein the second plurality of pads of the second integrated circuit die are located on a first surface of the second integrated circuit die, the second integrated circuit die further comprising a third plurality of pads on a second surface of the second integrated circuit die that is opposite to the first surface of the second integrated circuit die, the system further comprising a third integrated circuit die stacked on top of the second integrated circuit die, the third integrated circuit die comprising a third plurality of interconnect layers and a fourth plurality of pads electrically conductively coupled to the third plurality of interconnect layers, wherein individual pads of the third plurality of pads are bonded to a pad of the fourth plurality of pads.

Example C59 comprises the system of any one of Examples C45-C58, the system further comprising a third integrated circuit die comprising: a third substrate comprising silicon; a third logic standard cell located on the third substrate; a third plurality of interconnect layers located on the third substrate; and a third plurality of pads electrically conductively coupled to a third plurality of traces of the third plurality of interconnect layers, wherein individual pads of the first plurality of pads are attached to a pad of the third plurality of pads, and pitch of the first plurality of pads is less than about 500 nanometers.

Example C60 comprises the system of Example C59, wherein the third logic standard cell comprises a fin field-effect transistor.

Example C61 is a method comprising: forming an integrated circuit structure comprising a first substrate comprising silicon, a first logic standard cell located on the first substrate, a first plurality of interconnect layers, the first plurality of interconnect layers located on a first substrate comprising a transistor located on the first substrate, wherein the first logic standard cell has a first standard cell height; forming a first plurality of pads on a top-most interconnect layer of the first plurality of interconnect layers, the first plurality of pads electrically conductively coupled to a plurality of traces of the top-most interconnect layer, wherein the first logic standard cell has a first standard cell height; and attaching an integrated circuit die to the integrated circuit structure, wherein the integrated circuit die a second substrate comprising silicon, a second logic standard cell located on the first substrate, a second plurality of interconnect layers and a second plurality of pads electrically conductively coupled to a top-most interconnect layer of the second plurality of interconnect layers, attaching the integrated circuit die to the integrated circuit structure comprises bonding the first plurality of pads to the second plurality of pads, the second logic standard cell has a second standard cell height that is different than the first standard cell height, and a pitch of the first plurality of pads is less than about 500 nanometers.

Example C62 comprises the method of Example C61, wherein the pitch of the first plurality of pads is in a range of about 40-60 nanometers.

Example C63 comprises the method of Example C61 or C62, wherein: the first logic standard cell comprises a first transistor; the second logic standard cell comprises a second transistor; and a gate, source or drain of the first transistor is electrically conductively coupled to a gate, source, or drain of the second transistor.

Example C64 comprises the method of any one of Examples C61-C63, wherein the first logic standard cell comprises a first fin field-effect transistor (FinFET) and can accommodate a first maximum number of FinFET fins within the first standard cell height, the second logic standard cell comprises a second FinFET and can accommodate a second maximum number of FinFET fins within the second standard cell height, and the first maximum number of FinFET fins is different than the second maximum number of FinFET fins.

Example C65 comprises the method of any one of Examples C61-C64, wherein the first logic standard cell is belongs to a first plurality of first logic standard cells arranged in a first row located on the first substrate, the second logic standard cell belongs to a second plurality of second logic standard cells arranged in a second row located on the second substrate, the first logic standard cell comprises a first fin field-effect transistor (FinFET), the second logic standard cell comprises a second FinFET, the first row comprising a first maximum number of FinFET fins arranged along the first standard cell height, the second row comprising a second maximum number of FinFET fins arranged along the second standard cell height, and the first maximum number of FinFET fins is different than the second maximum number of FinFET fins.

Example C66 comprises the method of any one of Examples C61-C65, wherein a lateral area of the integrated circuit die is less than a lateral area of the first substrate.

Example C67 comprises the method of Example C61, wherein the first plurality of interconnect layers is a frontside metallization stack.

Example C68 comprises the method of Example C61, wherein the first plurality of interconnect layers is a backside metallization stack.

Example C69 comprises the method of any one of Examples C61-C68, further comprising forming the integrated circuit die.

Example C70 comprises the method of any one of Examples C61-C69, further comprising forming a third plurality of interconnect layers over the first plurality of interconnect layers and the integrated circuit die.

Example C71 comprises the method of any one of Examples C61-C70, wherein a first manufacturing process used to form the integrated circuit structure is different than a second manufacturing process used to form the integrated circuit die.

Example C72 comprises the method of any one of Examples C61-C71, wherein the integrated circuit die is attached to the integrated circuit structure via hybrid bonding.

Example C73 comprises the method of any one of Examples C61-C71, wherein the integrated circuit die is a first integrated circuit die, the plurality of traces of an interconnect layer of the first plurality of interconnect layers is a first plurality of traces, the method further comprising: forming a third plurality of pads electrically conductively coupled to a second plurality of metal traces of a top-most layer of the first plurality of interconnect layers; and attaching a second integrated circuit die comprising a third substrate comprising silicon, a third logic standard cell located on the third substrate, a third plurality of interconnect layers and a fourth plurality of pads attached to a top-most layer of the third plurality of interconnect layers, wherein individual pads of the fourth plurality of pads are bonded to a pad of the third plurality of pads, the third logic standard cell has a third standard cell height that is different from the first standard cell height and the second standard cell height, and a pitch of the third plurality of pads being less than about 500 nanometers.

## Claims

1. An apparatus, comprising:
a first integrated circuit die comprising:
a first substrate comprising silicon;
a first plurality of interconnect layers located on the first substrate; and
a first plurality of pads electrically conductively coupled to a first plurality of traces of the first plurality of interconnect layers; and
a second integrated circuit die comprising:
a second substrate comprising silicon;
a second plurality of interconnect layers located on the second substrate; and
a second plurality of pads electrically conductively coupled to a second plurality of traces of the second plurality of interconnect layers, wherein individual pads of the first plurality of pads are attached to a pad of the second plurality of pads, a pitch of the first plurality of pads is less than about 500 nanometers, a lateral area of the second integrated circuit die is less than a lateral area of the first integrated circuit die, and individual of the first plurality of pads and individual of the second plurality of pads comprise a metal.

2. The apparatus of claim 1, wherein the second integrated circuit die further comprises a third plurality of interconnect layers, the second substrate positioned between the second plurality of interconnect layers and the third plurality of interconnect layers.

3. The apparatus of any one of claims 1-2, wherein:
the first plurality of traces belong to a first interconnect layer of the first plurality of interconnect layers; and
the first plurality of pads electrically conductively coupled to the first plurality of traces by a plurality of vias that extend through one or more second interconnect layers of the first plurality of interconnect layers, individual of the plurality of vias extending from one of the first plurality of pads to one of the first plurality of traces.

4. The apparatus of any one of claims 1-3, wherein the first plurality of interconnect layers comprises all interconnect layers located on a surface of the first substrate and the first plurality of interconnect layers is located between the first substrate and the second integrated circuit die.

5. The apparatus of any one of claims 1-4 wherein the first plurality of traces belong to an interconnect layer that is a middle layer of the first plurality of interconnect layers.

6. The apparatus of any one of claims 1-5, wherein the second integrated circuit die is positioned between a top-most interconnect layer of the first plurality of interconnect layers and the first substrate.

7. The apparatus of any one of claims 1-6, wherein the first integrated circuit die further comprises a first transistor located on the first substrate and the second integrated circuit die comprises a second transistor located on the second substrate, a transistor type of the first transistor being a planar field-effect transistor (FET), fin FET, or gate-all-around FET (GAAFET); a transistor type of the second transistor being planar FET, fin FET or GAAFET; and the transistor type of the first transistor is different than the transistor type of the second transistor.

8. The apparatus of any one of claims 1-7, wherein the second plurality of pads of the second integrated circuit die are located on a first surface of the second integrated circuit die, the second integrated circuit die further comprising a third plurality of pads on a second surface of the second integrated circuit die that is opposite to the first surface of the second integrated circuit die, the apparatus further comprising a third integrated circuit die stacked on top of the second integrated circuit die, the third integrated circuit die comprising a third plurality of interconnect layers and a fourth plurality of pads electrically conductively coupled to the third plurality of interconnect layers, wherein individual pads of the third plurality of pads are bonded to a pad of the fourth plurality of pads.

9. The apparatus of any one of claims 1-8, wherein the second integrated circuit die comprises a six-transistor static random-access memory bitcell (6T SRAM bitcell).

10. The apparatus of claim 9, wherein a first pad of the second plurality of pads is electrically conductively coupled to a gate of a transistor of the 6T SRAM bitcell and a second pad of the second plurality of pads is electrically conductively coupled to a source or a drain of the transistor of the 6T SRAM bitcell.

11. The apparatus of any one of claims 1-10, wherein the second integrated circuit die comprises an array of six-transistor static random-access memory bitcells.

12. The apparatus of any one of claims 1-11, further comprising a printed circuit board, wherein the first integrated circuit die and the second integrated circuit die are attached to the printed circuit board.

13. The apparatus of claim 12, further comprising a housing enclosing the printed circuit board.

14. A method comprising:
forming an integrated circuit structure comprising a first substrate, a first transistor located on the first substrate, and a first plurality of interconnect layers located on the first substrate;
forming a first plurality of pads on a top-most interconnect layer of the first plurality of interconnect layers, the first plurality of pads electrically conductively coupled to a plurality of traces of the top-most interconnect layer; and
attaching an integrated circuit die to the integrated circuit structure, wherein the integrated circuit die comprises a second substrate, a second transistor located on the second substrate, a second plurality of interconnect layers, and a second plurality of pads electrically conductively coupled to a top-most interconnect layer of the second plurality of interconnect layers; wherein attaching the integrated circuit die to the integrated circuit structure comprises bonding the first plurality of pads to the second plurality of pads, a pitch of the first plurality of pads is less than about 500 nanometers, and a lateral area of the integrated circuit die is less than a lateral area of the first substrate.

15. The method of claim 14, wherein the integrated circuit die comprises a six-transistor static random-access memory bitcell (6T SRAM bitcell).
